# EUROPEAN PATENT APPLICATION

(11) **EP 4 266 387 A1**
(43) Date of publication of application: **25.10.2023**
(21) Application number: 21907189.1
(22) Date of filing: 20.12.2021
(51) Int. Cl.: H01L 33/62, H01L 33/52, H01L 33/58, H01L 33/48

(54) **LIGHT-EMITTING DIODE PACKAGE**

(30) Priority: 18.12.2020 US 202063127268 P
(71) Applicant: Seoul Viosys Co., Ltd., Ansan-si, Gyeonggi-do 15429 (KR)
(72) Inventor: NA, Junghyun, Ansan-Si Gyeonggi-do 15429 (KR); MIN, Seung Gu, Ansan-Si Gyeonggi-do 15429 (KR); PARK, Eun Ji, Ansan-Si Gyeonggi-do 15429 (KR); LEE, Young Jin, Ansan-Si Gyeonggi-do 15429 (KR)
(74) Representative: Isarpatent
(86) International application number: PCT/KR2021/019442
(87) International publication number: WO 2022/131885

(57) **Abstract**

Disclosed is a light emitting diode package. According to one embodiment, the light emitting diode package includes a body and a light emitting diode chip. The body includes a substrate and a sidewall formed on the substrate and may be formed with a cavity therein. The light emitting diode chip may be mounted on the substrate in the cavity of the body. The sidewall may include multiple inner side surfaces formed to surround the cavity. The inner side surfaces of the sidewall may include adjacent inner side surfaces forming an angle of 90 degrees or more therebetween. In addition, the substrate may include an insulating base, a first interconnect pattern formed on the base, a second interconnect pattern spaced apart from the first interconnect pattern, and an insulating region disposed inside the cavity to separate the first interconnect pattern from the second interconnect pattern.

## Description

### [Technical Field]

Embodiments of the present disclosure relate to a light emitting diode package.

### [Background Art]

Light emitting devices including compound semiconductors, such as GaN, AlGaN, and the like, have many advantages including broad and easily adjustable band-gap energy and may be used in various ways, for example, as a light emitting device, as a light receiving device, and as various diodes.

In particular, with development of thin film growth techniques and thin film materials, a light emitting device, such as a light emitting diode or a laser diode, can realize various colors, such as a red color, a green color, a blue color, and UV light, and white light having good efficiency using phosphors or through combination of colors or use of phosphors. Such a light emitting device has various advantages including longer lifespan, lower power consumption, and rapider response than existing light sources, such as a fluorescent lamp, an incandescent lamp, and the like.

Furthermore, with development of materials capable of generating photocurrent through absorption of light in various wavelength bands, it is possible to use light in a wide range of wavelengths from γ-rays to the radio wavelengths in manufacture of light receiving devices, such as photodetectors or solar cells, using group III-V or II-VI compound semiconductors.

Accordingly, application of the light emitting device expands to transmission modules of optical communication devices, cold cathode fluorescence lamps (CCFL) constituting a backlight of an LCD display, white light emitting diode lighting devices capable of replacing fluorescent lamps or incandescent light bulbs, automobile head lamps, traffic lights, sensors for detecting gas or fire, and the like. In addition, the light emitting device can be applied to high frequency application circuits, other power control devices, and communication modules.

In particular, semiconductor devices emitting UV light can be used for curing, in medicine and for sterilization.

On the other hand, despite active study on a light emitting diode package, the light emitting diode package still has a problem of deterioration in reliability and efficiency over time.

### [Disclosure]

### [Technical Problem]

Embodiments of the present disclosure provide a light emitting diode package achieving improvement in reliability by preventing generation of cracks on a lens.

Embodiments of the present disclosure provide a light emitting diode package capable of improving light extraction efficiency.

### [Technical Solution]

In accordance with one embodiment of the present disclosure, a light emitting diode package includes a body and a light emitting diode chip. The body includes a substrate and a sidewall formed on the substrate and may be formed with a cavity therein. The light emitting diode chip may be mounted on the substrate in the cavity of the body. The sidewall may include multiple inner side surfaces formed to surround the cavity. The inner side surfaces of the sidewall may include adjacent inner side surfaces forming an angle of 90 degrees or more therebetween. In addition, the substrate may include an insulating base, a first interconnect pattern formed on the base, a second interconnect pattern spaced apart from the first interconnect pattern, and an insulating region disposed inside the cavity to separate the first interconnect pattern from the second interconnect pattern.

The sidewall may include an even number of inner side surfaces greater than or equal to 4.

The inner side surfaces of the sidewall may include inner side surfaces facing each other and having the same length.

The inner side surfaces of the sidewall may include inner side surfaces facing each other and symmetrical to each other.

An upper surface of the sidewall may be divided into multiple regions. Here, some regions of the upper surfaces of the side wall may have different areas than the other regions thereof.

The light emitting diode package may further include a lens disposed on an upper surface of the sidewall and covering the cavity.

The light emitting diode package may further include a bonding agent interposed between the lens and the upper surface of the sidewall. In addition, the upper surface of the sidewall may be divided into multiple regions. Here, some regions of the upper surface of the side wall may have different areas than the other regions thereof. Further, the multiple regions may include regions facing each other and having the same area.

The insulating region may include a first insulating region and a second insulating region. The first insulating region may have a greater length than the second insulating region. Here, the first insulating region may be disposed parallel to one side of the light emitting diode chip. In addition, the second insulating region may be disposed parallel to the other side of the light emitting diode chip.

The light emitting diode package may further include a short preventing portion formed on the interconnect pattern between the light emitting diode chip and the insulating region.

For example, the short preventing portion may be a groove formed on the interconnect pattern formed on an upper side of the base.

For example, the short preventing portion may be a dam formed on the interconnect pattern formed on an upper side of the base. Here, an upper surface of the dam may be placed above an upper surface of the interconnect pattern.

In accordance with another embodiment of the present disclosure, a light emitting diode package includes a body and a light emitting diode chip. The body includes a substrate and a sidewall formed on the substrate and may be formed with a cavity therein. The light emitting diode chip may be mounted on the substrate in the cavity of the body. The sidewall includes at least four inner side surfaces formed to surround the cavity. The inner side surfaces of the sidewall may include adjacent inner side surfaces forming an angle of 90 degrees or more therebetween. In addition, the substrate may include an insulating base, a first interconnect pattern formed on the base, a second interconnect pattern spaced apart from the first interconnect pattern, an insulating region disposed inside the cavity to separate the first interconnect pattern from the second interconnect pattern, and a short preventing portion disposed between the light emitting diode chip and the insulating region.

The inner side surfaces of the sidewall may include inner side surfaces facing each other and having the same length.

The inner side surfaces of the sidewall may include inner side surfaces facing each other and symmetrical to each other.

The insulating region may include a first insulating region and a second insulating region. The first insulating region may have a greater length than the second insulating region. The first insulating region may be disposed parallel to one side of the light emitting diode chip. In addition, the second insulating region may be disposed parallel to the other side of the light emitting diode chip.

The short preventing portion may include at least some region parallel to the first insulating region.

The short preventing portion may include at least some region parallel to the second insulating region.

For example, the short preventing portion may a groove shape or a dam shape.

The short preventing portion may have a greater length than the insulating region.

### [Advantageous Effects]

The light emitting diode package according to the embodiments of the present disclosure can achieve improvement in reliability by preventing separation of the lens.

In addition, the light emitting diode package according to the embodiments of the present disclosure can achieve improvement in reliability and lifespan by minimizing electrical failure.

Further, the light emitting diode package according to the embodiments of the present disclosure can improve light extraction efficiency.

### [Description of Drawings]

FIG. 1a is a plan view of a light emitting diode package according to a first embodiment of the present disclosure.
FIG. 1b is a cross-sectional view (A-A') of the light emitting diode package according to the first embodiment of the present disclosure.
FIG. 2a is a plan view of a light emitting diode package according to a second embodiment of the present disclosure.
FIG. 2b is a cross-sectional view (B-B') of the light emitting diode package according to the second embodiment of the present disclosure.
FIG. 2c is a cross-sectional view of another example of the light emitting diode package according to the second embodiment of the present disclosure.
FIG. 3 is an exemplary view of a light emitting diode package according to a third embodiment of the present disclosure.
FIG. 4a is a plan view of a light emitting diode package according to a fourth embodiment of the present disclosure.
FIG. 4b is a cross-sectional view (C-C') of the light emitting diode package according to the fourth embodiment of the present disclosure.
FIG. 5 is an exemplary view of a light emitting diode package according to a fifth embodiment of the present disclosure.
FIG. 6 is an exemplary view of a light emitting diode package according to a sixth embodiment of the present disclosure.
FIG. 7 is an exemplary view of a light emitting diode package according to a seventh embodiment of the present disclosure.
FIG. 8 is an exemplary view of a light emitting diode package according to an eighth embodiment of the present disclosure.
FIG. 9a is a plan view of a light emitting diode package according to a ninth embodiment of the present disclosure.
FIG. 9b is a cross-sectional view (D-D') of the light emitting diode package according to the ninth embodiment of the present disclosure.
FIG. 10 is an exemplary view of a light emitting diode package according to a tenth embodiment of the present disclosure.
FIG. 11 is an exemplary view of a light emitting diode package according to an eleventh embodiment of the present disclosure.
FIG. 12a is a plan view of a light emitting diode package according to a twelfth embodiment of the present disclosure.
FIG. 12b is a cross-sectional view (E-E') of the light emitting diode package according to the twelfth embodiment of the present disclosure.
FIG. 12c is another cross-sectional view (F-F') of the light emitting diode package according to the twelfth embodiment of the present disclosure.
FIG. 13 is an exemplary view of a light emitting diode package according to a thirteenth embodiment of the present disclosure.
FIG. 14a is a cross-sectional view of a light emitting diode package according to a fourteenth embodiment of the present disclosure.
FIG. 14b is another cross-sectional view of a light emitting diode package according to the fourteenth embodiment of the present disclosure.
FIG. 15a is a cross-sectional view of a light emitting diode package according to a fifteenth embodiment of the present disclosure.
FIG. 15b is another cross-sectional view of a light emitting diode package according to the fifteenth embodiment of the present disclosure.
FIG. 16a is a plan view of a light emitting diode package according to a sixteenth embodiment of the present disclosure.
FIG. 16b is a cross-sectional view (G-G') of the light emitting diode package according to the sixteenth embodiment of the present disclosure.
FIG. 17 is an exemplary view of a light emitting diode package according to a seventeenth embodiment of the present disclosure.
FIG. 18 is an exemplary view of a light emitting diode package according to an eighteenth embodiment of the present disclosure.
FIG. 19a is a plan view of a light emitting diode package according to a nineteenth embodiment of the present disclosure.
FIG. 19b is a cross-sectional view (H-H') of the light emitting diode package according to the nineteenth embodiment of the present disclosure.
FIG. 20 is an exemplary view of a light emitting diode package according to a twentieth embodiment of the present disclosure.
FIG. 21 is an exemplary view of a light emitting diode package according to a twenty first embodiment of the present disclosure.
FIG. 22a is a plan view of a light emitting diode package according to a twenty second embodiment of the present disclosure.
FIG. 22b is a cross-sectional view (I-I') of the light emitting diode package according to the twenty second embodiment of the present disclosure.
FIG. 22c is another cross-sectional view (J-J') of the light emitting diode package according to the twenty second embodiment of the present disclosure.
FIG. 23 is an exemplary view of a light emitting diode package according to a twenty third embodiment of the present disclosure.
FIG. 24a is a cross-sectional view of a light emitting diode package according to a twenty fourth embodiment of the present disclosure.
FIG. 24b is another cross-sectional view of the light emitting diode package according to the twenty fourth embodiment of the present disclosure.
FIG. 25a is a cross-sectional view of a light emitting diode package according to a twenty fifth embodiment of the present disclosure.
FIG. 25b is another cross-sectional view of the light emitting diode package according to the twenty fifth embodiment of the present disclosure.
FIG. 26 is an exemplary view of a light emitting diode package according to a twenty sixth embodiment of the present disclosure.

### [Mode for Invention]

Hereinafter, exemplary embodiments of the present disclosure will be described in detail with reference to the accompanying drawings. The following embodiments are given by way of illustration to provide a thorough understanding of the present disclosure to those skilled in the art. Therefore, the present disclosure is not limited to the following embodiments and may be realized in different ways. The present embodiments may be combined with each other and the scope of the present disclosure is not limited to each of the embodiments described below. In addition, even if a feature described in a specific embodiment is not described in another embodiment, the feature can be understood as a description related to another embodiment unless the description is inconsistent with or contradicts the corresponding feature in the other embodiment.

In addition, it should be noted that the drawings are not to precise scale and some of the dimensions, such as width, length, thickness, and the like, are exaggerated for clarity of description in the drawings. Further, it will be understood that, when an element is referred to as being placed "above" or "on" another element, the element can be placed directly above or on the other element, or intervening element(s) may also be present therebetween. The same components will be denoted by the same reference numerals throughout the specification.

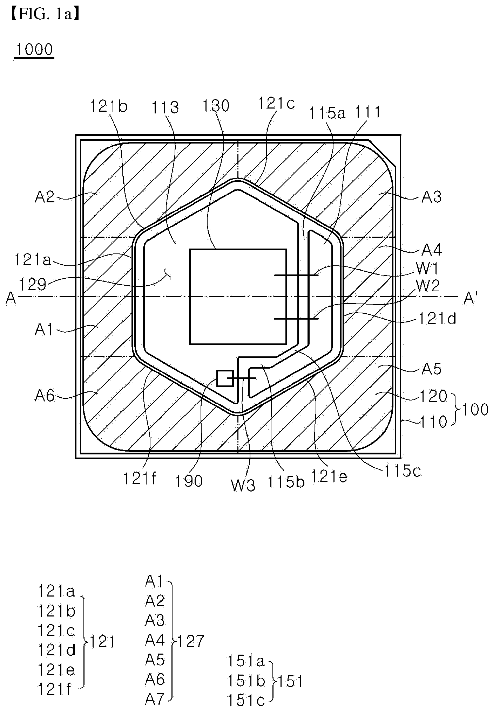

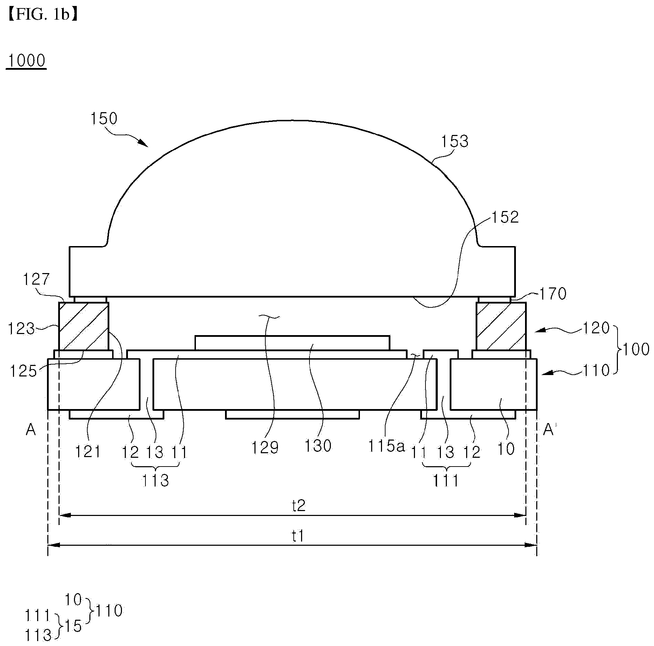

FIG. 1 is exemplary views of a light emitting diode package according to a first embodiment of the present disclosure.

FIG. 1a is a plan view of the light emitting diode package according to the first embodiment of the present disclosure. In addition, FIG. 1b is a cross-sectional view (A-A') of the light emitting diode package according to the first embodiment of the present disclosure.

FIG. 1a is a plan view of a body and a light emitting diode chip excluding a lens. In all embodiments described below, plan views show a body and a light emitting diode chip excluding a lens.

Referring to FIG. 1a and FIG. 1b, the light emitting diode package 1000 according to the first embodiment may include a body 100 defining a cavity 129 therein, a light emitting diode chip 130 disposed in the cavity 129, a protective element 190 spaced apart from the light emitting diode chip 130, an insulating region 115 disposed parallel to at least one side of the light emitting diode chip 130, a lens 150 disposed on an upper surface of the body 100, and a bonding layer 170 assisting in adhesion between the body 100 and the lens 150.

The body 100 may include a substrate 110 and a sidewall 120. The substrate 110 may be a lower portion of the body 100 and the sidewall 120 may be an upper portion of the body 100. That is, the substrate 100 may be placed under the sidewall 120. The sidewall 120 may be formed on an upper surface of the substrate. In addition, the sidewall 120 may define the cavity 129 that exposes at least part of the upper surface of the substrate 110.

The substrate 110 and the sidewall 120 are separate components and may be connected to each other to constitute the body 100. Alternatively, the substrate 110 and the sidewall 120 may be integrally formed with each other.

The body 100 may be formed of a metallic or ceramic material. Here, the substrate 110 and the sidewall 120 may be formed of the same material or different materials.

The substrate 110 may be an insulating substrate including a ceramic material. The ceramic material may include low temperature co-fired ceramic (LTCC) or high temperature co-fired ceramic (HTCC). For example, the substrate 110 may include a ceramic material such as AlN and the like. However, it should be understood that the present disclosure is not limited thereto and the substrate 110 may include other ceramic materials such as SiO₂, SiₓO_{y}, Si₃N₄, SiₓN_{y}, SiOₓN_{y}, Al₂O₃, and the like.

The substrate 110 may be a printed circuit board (PCB) or a metal substrate.

The sidewall 120 may be formed by plating with a metal. For example, the sidewall 120 may be formed of Au. However, it should be understood that the sidewall 120 is not limited thereto and may be formed on the upper surface of the substrate 110 by various methods using various materials.

When the sidewall 120 is formed of a metal, a first interconnect pattern 111 and a second interconnect pattern 112 formed on the substrate 110 may be formed by the same method using the same material as the sidewall 120.

In this embodiment, the substrate 110 may have a width t1 of about 2.0 mm to about 12 mm. Specifically, the substrate 110 may have a width t1 of about 3.5 mm.

The substrate 110 may include a base 10 and an interconnect pattern 15.

The base 10 may be formed of an insulating material. For example, the base 10 may be formed of the ceramic material. Alternatively, the base 10 may be formed of a metal having an insulating material coated on a surface thereof.

Referring to FIG. 1a and FIG. 1b, the interconnect pattern 15 may include the first interconnect pattern 111 and the second interconnect pattern 113.

Each of the first interconnect pattern 111 and the second interconnect pattern 113 may include an upper interconnect pattern 11 formed on an upper surface of the base 10, a lower interconnect pattern 12 formed on a lower surface of the base 10, and a via 13 formed in the base 10 and electrically connecting the upper interconnect pattern 11 to the lower interconnect pattern 12.

The first interconnect pattern 111 and the second interconnect pattern 113 may supply electric power to the light emitting diode chip 130 and the protective element 190.

Referring to FIG. 1a and FIG. 1b, the first interconnect pattern 111 is placed at one side of the light emitting diode chip 130 and the second interconnect pattern 113 is placed at a lower side of the light emitting diode chip 130.

The interconnect pattern 15 may be formed of an electrically conductive material. For example, the interconnect pattern 15 may be formed of a metal, such as gold (Au), silver (Ag), platinum (Pt), titanium (Ti), copper (Cu), nickel (Ni), tantalum (Ta), tin (Sn), aluminum (Al), tungsten (W), and palladium (Pd). In addition, the interconnect pattern 15 may have a monolayer structure or a multilayer structure.

A lower surface 125 of the sidewall 120 may contact the upper surface of the substrate 110. In addition, an upper surface 127 of the sidewall 120 may contact a lower surface of the lens 150. Further, an inner side surface of the sidewall 120 may define the cavity 129. Accordingly, the structure of the cavity 129 may be modified according to the structure of the inner side surface 121 of the sidewall 120.

The cavity 129 may be an air gap. The air gap refers to a space filled with air. That is, the cavity 129 may be filled with air. However, it should be understood that the present disclosure is not limited thereto and the cavity 129 may be filled with various gases, for example, nitrogen and the like. Alternatively, the cavity 129 may be filled with a polymer resin.

An outer side surface 123 of the sidewall 120 may constitute an outer wall of the body 100 together with an outer side surface of the substrate 110.

Referring to FIG. 1a, a width t2 of the outer side surface of the sidewall 120 may be narrower than a width t1 of the outer side surface of the substrate 110. Here, the width of the outer side surface of each of the sidewall 120 and the substrate 110 refers to a distance between outer side surfaces facing each other.

In addition, each of corners of the outer side surface 123 of the sidewall 120 may be formed in a curved shape. That is, as shown in FIG. 1a, the corners of the outer periphery of the sidewall 120 may have a curved structure.

Each corner of the outer side surface 123 of the sidewall 120 is formed in a curved shape, thereby enabling stable formation of the sidewall 120 without cracking. However, it should be understood that the sidewall 120 according to the present disclosure is not limited thereto.

The size and structure of the cavity 129 may be determined according to the structure of the inner side surface 121 of the sidewall 120, whereby the area and structure of the upper surface 127 of the sidewall 120 can also be determined corresponding thereto.

The sidewall 120 may include n or more inner side surfaces 121. Here, n is a natural number of 4 or more.

For the sidewall 120 including an even number of inner side surfaces 121, the inner side surfaces 121 of the sidewall 120 facing each other may have the same width (length). In addition, the sidewall 121 may have inner side surfaces 121 facing each other and symmetrical to each other. With the symmetrical structure of the inner side surfaces 121 of the sidewall 120, the light emitting diode package allows light emitted from the light emitting diode chip 130 to be uniformly discharged through the entirety of an upper region of the cavity 129, when the light emitting diode chip 130 is disposed in the cavity 129 such that an optical axis of the light emitting diode chip 130 is consistent with a central axis of the cavity 129. That is, the above structure can improve luminous uniformity at the boundary between the cavity 129 and the lens 150.

The lens 150 is disposed on the upper surface 127 of the sidewall 120.

The lens 150 may protect the light emitting diode chip 130 in the cavity 129 from external environments. In addition, the lens 150 may adjust a profile of light emitted from the light emitting diode chip 130.

The bonding layer 170 may be further formed between the upper surface 127 of the sidewall 120 and the lens 150. The bonding layer 170 may be formed of a bonding material that can bond the sidewall 120 to the lens 150. For example, the bonding layer 170 may be formed of a material including at least one selected from among resins, such as a silicone resin and an epoxy resin, and metals.

For the sidewall 120 including the inner side surfaces 121 facing each other and symmetrical to each other, the upper surfaces 127 of the sidewall 120, which are connected to the inner side surfaces 121 facing each other, may have the same area. For example, in FIG. 1a, on the upper surface 127 of the sidewall 120, a first region A1 may have the same area as a fourth region A4. In addition, a second region A2 may have the same area as a fifth region A5. Further, a third region A3 may have the same area as a sixth region A6.

As such, since the regions symmetrical to each other have the same area, the bonding material may also be deposited in the same amount to the symmetrical regions on the upper surface 127 of the sidewall 120. Accordingly, the bonding material between the lens 150 and the upper surface 127 of the sidewall 120 may be uniformly deposited with reference to any central line on the upper surface 127 of the sidewall 120. Here, the central line refers to a straight line connecting one side of the upper surface 127 of the sidewall 120 to the other side thereof. Further, the one side and the other side refer to opposite sides or corners facing each other. Since the bonding material can be uniformly deposited on the regions symmetrical to each other, it is possible to prevent the lens 150 from being slanted to one side due to a difference in deposited amount of the bonding material that causes a difference in height of the bonding layer 170. Further, it is possible to prevent the lens 150 from being moved or rotated due to a difference in bonding strength of the bonding layer 170 between the regions on the upper surface 127 of the sidewall 120 or from being detached from the upper surface 127 of the sidewall 120 at a portion thereof, which exhibits low bonding strength.

Referring to FIG. 1a, the sidewall 120 may include first to sixth inner side surfaces 121a, 121b, 121c, 121d, 121e, 121f. The first to sixth inner side surfaces 121a, 121b, 121c, 121d, 121e, 121f are sequentially arranged in the clockwise direction, with adjacent inner side surfaces connected to each other. Here, the first inner side surface 121a and the fourth inner side surface 121d are disposed parallel to opposite sides of the substrate 110. Further, the second inner side surface 121b, the third inner side surface 121c, the fifth inner side surface 121e, and the sixth inner side surface 121f may be disposed to face the corners of the sidewall 120 or the corners of the substrate 110.

According to this embodiment, the first inner side surface 121a and the fourth inner side surface 121d may have the same length as or a greater length than the second inner side surface 121b, the third inner side surface 121c, the fifth inner side surface 121e, and the sixth inner side surface 121f. If the second inner side surface 121b, the third inner side surface 121c, the fifth inner side surface 121e, and the sixth inner side surface 121f have a shorter length than the first inner side surface 121a and the fourth inner side surface 121d, there can be a problem that a sufficient area for mounting the light emitting diode chip 130 and the protective element 190 is not secured.

Referring to FIG. 1a, the sidewall 120 may have a structure in which the adjacent inner side surfaces 121 are connected to each other to form an angle of 90 degrees or more therebetween. If the adjacent inner side surfaces 121 are connected to each other to form an angle of less than 90 degrees therebetween, the area for the cavity 129 cannot be sufficiently secured, thereby making it difficult to mount the light emitting diode chip 130 and the protective element 190 therein. Further, if the adjacent inner side surfaces 121 are connected to each other to form an angle of 90 degrees therebetween, a sufficient area of the cavity 129 can be secured. However, a sufficient area of the upper surface 127 of the sidewall 120 for deposition of the bonding material is not secured to allow the lens 150 to be sufficiently secured to the sidewall 120, causing deterioration in adhesion between the sidewall 120 and the lens 150. Referring to FIG. 1b, in the sidewall 120, the inner side surfaces 121 have a planar structure perpendicular to the upper surface of the substrate 110. However, it should be understood that the structure of the sidewall 120 is not limited thereto and the inner side surfaces 121 may include at least one planar or curved surface inclined at various angles with respect to the upper surface of the substrate.

Referring to FIG. 1a, the upper surface 127 of the sidewall 120 may include a first region A1 connected to the first inner side surface 121a, a second region A2 connected to the second inner side surface 121b, a third region A3 connected to the third inner side surface 121c, a fourth region A4 connected to the fourth inner side surface 121d, a fifth region A5 connected to the fifth inner side surface 121e, and a sixth region A6 connected to the sixth inner side surface 121f. A border line between two adjacent regions among the first to sixth regions A1, A2, A3, A4, A5, A6 may be the shortest straight line between a corner of each of the inner side surfaces 121 of the sidewall 120 and the outer side surface 123 of the sidewall 120.

The first region A1 may have the same area as the fourth region A4. In addition, the second region A2, the third region A3, the fifth region A5 and the sixth region A6 may have the same area. Further, the first region A1 and the fourth region A4 may have a narrower area than the second region A2, the third region A3, the fifth region A5 and the sixth region A6.

Accordingly, the bonding layer 170 formed in each of the first region A1 and the fourth region A4 may have a larger area than the bonding layer 170 formed in each of the second region A2, the third region A3, the fifth region A5 and the sixth region A6. Here, each of the second region A2, the third region A3, the fifth region A5 and the sixth region A6 includes an outer corner of the upper surface 127 of the sidewall 120. That is, the second region A2, the third region A3, the fifth region A5 and the sixth region A6 each including the outer corner of the upper surface 127 of the sidewall 120 are formed to have a large area.

Since the regions including the outer corners of the upper surface 127 of the sidewall 120 have a large area, the bonding material spreads broadly and can be prevented from agglomerating at the corners of the upper surface. Accordingly, the bonding layer 170 may have as small a step as possible over the entire region on the upper surface 27 of the sidewall 120. Accordingly, the lens 150 can be prevented from being detached, rotated and slanted due to a stepped structure of the bonding layer 170, thereby improving reliability and light extraction efficiency of the light emitting diode package 1000.

In addition, the light emitting diode package 1000 can prevent the bonding material from entering the cavity 129 from the upper surface 127 of the sidewall 120.

A straight distance between the first inner side surface 121a and the fourth inner side surface 121d at the center of the cavity 129 and another straight distance perpendicular to the straight distance at the center of the cavity 129 may be in the range of 2.5 mm to 2.8 mm, specifically 2.64 mm.

The cavity 129 may have a sufficient size to mount the light emitting diode chip 130 and the protective element 190 therein.

Further, the cavity 129 may have a sufficient size such that the light emitting diode chip 130 and the protective element 190 can be connected to first, second and third wires W1, W2, W3 without interference.

The light emitting diode chip 130 may be disposed in the cavity 129 to be spaced apart from the sidewall 120. For example, the light emitting diode chip 130 may be disposed to overlap a vertical line at the center of the cavity 129. More specifically, the light emitting diode chip 130 may be disposed in a region where a central axis of the light emitting diode chip 130 overlaps a central axis of the cavity 129. With this placement, the light emitting diode package 1000 according to this embodiment can secure a uniform beam angle in any direction in plan view. Further, the light emitting diode package 1000 according to this embodiment can realize uniform brightness.

Referring to FIG. 1b, the light emitting diode chip 130 is disposed on an upper surface of the second interconnect pattern 113. Here, one side of the light emitting diode chip 130 and one side of the second interconnect pattern 113 are not placed on the same vertical line. Here, the one side of the light emitting diode chip 130 and the one side of the second interconnect pattern 113 face the same inner side surfaces 121 of the sidewall 120. However, it should be understood that the structure of the light emitting diode package 1000 is not limited thereto. Alternatively, the light emitting diode chip 130 may be disposed on the second interconnect pattern 113 such that the one side of the light emitting diode chip 130 and the one side of the second interconnect pattern 113 are placed on the same vertical line.

In one embodiment, the cavity 129 may be provided with a single light emitting diode chip 130. The light emitting diode chip 130 may have a large area. For example, the light emitting diode chip 130 may have a size of 1,420 µm x 1,420 µm.

Alternatively, the cavity 129 may be provided with multiple light emitting diode chips 130 and multiple protective elements 190. For example, the cavity 129 may be provided with at least four light emitting diode chips 130. Here, each of the light emitting diode chip 130 may have a size of 575 µm x 575 µm. Further, the light emitting diode chips 130 may be arranged at an interval of at least 250 µm or more to secure sufficient insulation between circuits including interconnect patterns formed on the substrate 110.

The light emitting diode chips 130 may be bonded to the second interconnect pattern 113 via an electrically conductive bonding agent, for example, Ag paste. However, it should be understood that the electrically conductive bonding agent is not limited to the Ag paste. The electrically conductive bonding agent may be selected from any electrically conductive bonding agents capable of bonding electrodes (not shown) of the light emitting diode chip 130 to the second interconnect pattern 113 while achieving electrical connection therebetween.

The light emitting diode chip 130 may be connected to the first interconnect pattern 111 via the first wire W1 and the second wire W2. That is, according to this embodiment, the electrodes of the light emitting diode chip 130 may be electrically connected to the interconnect pattern 15 of the substrate 110 by wire bonding.

The light emitting diode chip 130 according to this embodiment may be a vertical type light emitting diode chip having electrodes at upper and lower sides thereof, respectively. Alternatively, the light emitting diode chip 130 may be a horizontal type or flip-chip type light emitting diode chip.

It should be understood that electrical connection between the light emitting diode chip 130 and the substrate 110 is not limited to wire bonding. The light emitting diode chip 130 may be electrically connected to the substrate 110 by at least one method selected from among wire bonding, die bonding and flip-chip bonding according to the inner structure of the light emitting diode chip 130 and the structure of the interconnect pattern 15 formed on the substrate 110.

The light emitting diode chip 130 may include a light emitting structure including a compound semiconductor. The light emitting structure may include a first conductivity type semiconductor layer, a second conductivity type semiconductor layer, and an active layer interposed between the first conductivity type semiconductor layer and the second conductivity type semiconductor layer.

The first conductivity type semiconductor layer may include n-type dopants, such as Si, Ge and Sn, and the second conductivity type semiconductor layer may include p-type dopants, such as Mg, Sr, and Ba. The first conductivity type semiconductor layer may include GaN or AlGaN containing Si as a dopant and the second conductivity type semiconductor layer may include GaN or AlGaN containing Mg as a dopant.

Each of the first conductivity type semiconductor layer and the second conductivity type semiconductor layer may be composed of a single layer or multiple layers, and may include super-lattice layers.

The active layer may include a single quantum well structure or a multi-quantum well structure.

The light emitting diode chip 130 may generate and emit visible light, infrared light, and ultraviolet light. For example, the light emitting diode chip 130 may emit UV light having a wavelength of about 200 nm to 420 nm.

The protective element 190 may be disposed on the second interconnect pattern 113 in the cavity 129.

The protective element 190 may protect the light emitting diode chip 130 from reverse voltage, static electricity and surge current by maintaining a constant voltage despite fluctuations in current. For example, the protective element 190 may include a Zener diode or a transient voltage suppression (TVS) diode.

The protective element 190 is spaced apart from the light emitting diode chip 130. The protective element 190 is connected to the second interconnect pattern 113 through an electrically conductive bonding agent and may be electrically connected to the first interconnect pattern 110 through the first wire W.

Referring to FIG. 1a, the insulating region 115 may be formed between the first interconnect pattern 111 and the second interconnect pattern 113. The first interconnect pattern 111 is spaced apart from the second interconnect pattern 113 to be electrically insulated therefrom by the insulating region 115.

Referring to FIG. 1b, the insulating region 115 is a region in which the first interconnect pattern 111 is spaced apart from the second interconnect pattern 113. That is, the insulating region 115 may be a space in which the first interconnect pattern 111 is spaced apart from the second interconnect pattern 113. Alternatively, the insulating region 115 may be filled with an insulating material. For example, the insulating region 115 may be filled with a material including at least one selected from among PSR (Photoimageable Solder Resist), white silicone, silicone resins, epoxy resins, polyphthalamide (PPA), polycarbonate resins, polyphenylene sulfide (PPS), ABS resins, phenol resins, and acrylic resins. Alternatively, the insulating region 115 may be filled with the base 10 of the substrate 110.

The insulating region 115 may be disposed parallel to at least two sides of the light emitting diode chip 130.

The insulating region 115 may include a first insulating region 115a and a second insulating region 115b. The first insulating region 115a and the second insulating region 115b may be formed at least partially parallel to different sides of the light emitting diode chip 130, respectively. For example, the first insulating region 115a may be formed between one side of the light emitting diode chip 130 and the inner side surface 121 of the sidewall 120 parallel to the one side of the light emitting diode chip to be placed between the first interconnect pattern 111 and the second interconnect pattern 113. In addition, the second insulating region 115b may be formed at least partially parallel to the other side of the light emitting diode chip 130 facing a corner of the inner side surface 121 of the sidewall 120. Here, the one side and the other side of the light emitting diode chip 130 refer to sides sharing the same corner. Referring to FIG. 1a, the second insulating region 115b may be bent at a certain point. Accordingly, the second insulating region 115b may include a portion formed parallel to the other side of the light emitting diode chip 130 and bent parallel to one side of the protective element 190.

The first insulating region 115a may have a greater length than the second insulating region 115b.

The insulating region 115 may further include a third insulating region 115c. The third insulating region 115c may be connected at one end thereof to the first insulating region 115a and at the other end thereof to the second insulating region 115b. In addition, at least part of the third insulating region 11c may be formed parallel to the inner side surface 121 of the sidewall 120 facing one of the corners of the light emitting diode chip 130. For example, the third insulating region 115c may be disposed parallel to the fifth inner side surface 121e of the sidewall 120.

An outer side surface 151 of the lens 150 disposed on the body 100 may have the same maximum width as or a smaller maximum width than the outer side surface 123 of the sidewall 120. That is, the outer side surface 151 of the lens 150 may be placed on the same vertical line as the outer side surface 123 of the sidewall 120 or may be placed inside the outer side surface 123 of the sidewall 120.

At least part of a lower surface 152 of the lens 150 may be flat. For example, a portion of the lower surface 512 of the lens 150 facing the sidewall 120 may be flat. Alternatively, the entirety of the lower surface 152 of the lens 150 may be flat.

An upper surface 153 of the lens 150 may include a convex structure. The convex structure of the upper surface 153 of the lens 150 may be placed above the cavity 129. More specifically, the upper surface 153 of the lens 150 may include a convex portion 154 protruding from a central region thereof and a flat portion 155 formed along the periphery of the convex portion 154. Here, the center of the convex portion 154 may be placed on an optical axis of the light emitting diode chip 130.

The convex portion 154 may control the beam angle of light emitted from the light emitting diode chip 130. In addition, the convex portion 154 may have the same width as or a greater width than the light emitting diode chip 130 in a horizontal direction thereof.

The light emitting diode package 1000 according to this embodiment may have a beam angle of about 50 degrees to 80 degrees due to the lens 150. Preferably, the light emitting diode package 1000 may have a beam angle of about 60 degrees to 65 degrees.

The lens 150 may be formed of a material allowing transmission of light emitted from the light emitting diode chip 130 therethrough. For example, the lens 150 may be formed of a material, such as silicone, epoxy, oxides, and nitrides. Alternatively, the lens 150 may be formed of a glass material. For example, the lens 150 may be formed of a transparent material, for example, LiF, MgF₂, CaF₂, BaF₂, Al₂O₃, SiO₂, or optical glass (N-BK7). In addition, the lens 150 may be formed of quartz crystals (SiO₂).

Next, light emitting diode packages according to various embodiments of the present disclosure will be described. Here, the following description will focus on different features of the light emitting diode packages according to the following embodiments from the light emitting diode package according to the above embodiment. Thus, for details of omitted or briefly described components, refer to the description of the above embodiment.

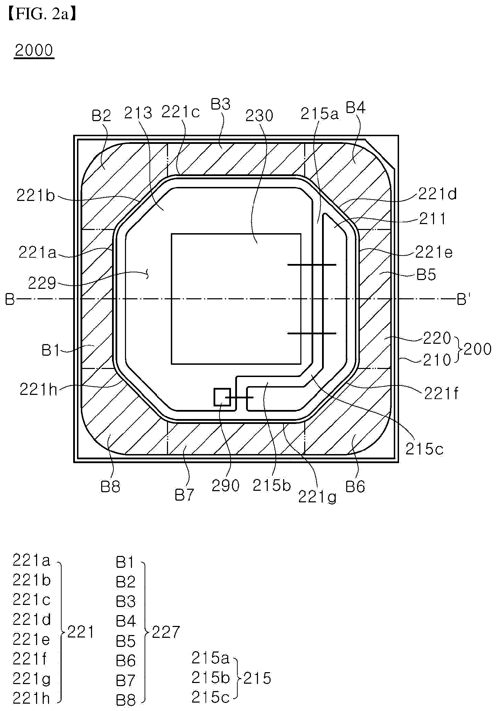

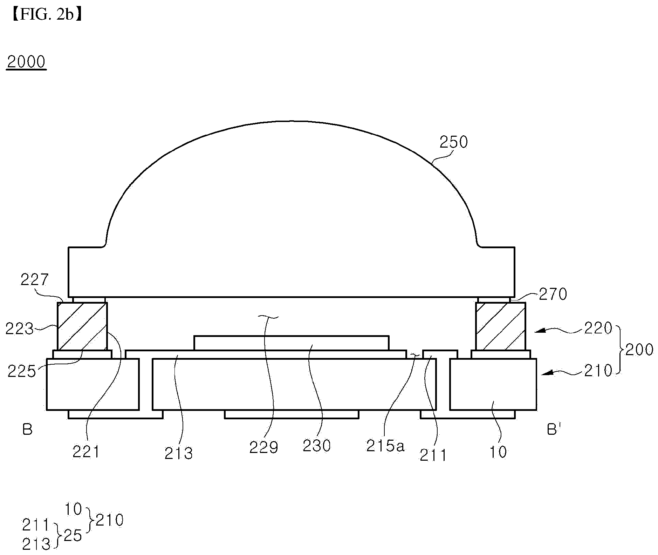

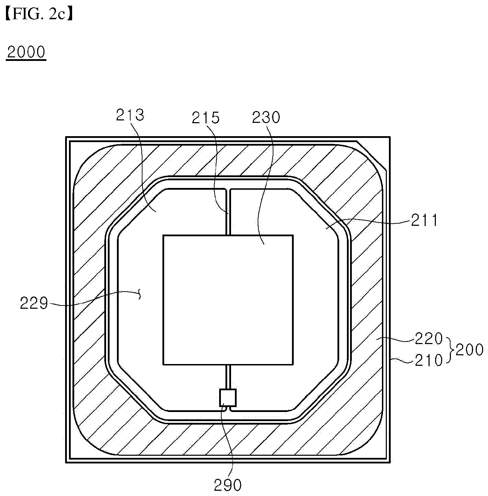

FIG. 2 is an exemplary view of a light emitting diode package according to a second embodiment of the present disclosure.

FIG. 2a is a plan view of a light emitting diode package according to the second embodiment of the present disclosure. FIG. 2b is a cross-sectional view (B-B') of the light emitting diode package according to the second embodiment of the present disclosure. FIG. 2c is a view of another example of the light emitting diode package according to the second embodiment of the present disclosure.

The light emitting diode package 2000 according to the second embodiment may include a cavity 229 having an octagonal cross-sectional shape.

Referring to FIG. 2a and FIG. 2b, a sidewall 220 includes 8 inner side surfaces 221 and may define the cavity 229 having an octagonal shape therein.

According to this embodiment, the inner side surfaces 221 of the sidewall 220 may include first to eight inner side surfaces 221a, 221b, 221c, 221d, 221e, 221f, 221g, 221h.

The first inner side surface 221a, the third inner side surface 221c, the fifth inner side surface 221e and the seventh side surface 221g are disposed parallel to side surfaces of the substrate 210 adjacent thereto, respectively. In addition, the second inner side surface 221b, the fourth inner side surface 221d, the sixth side surface 221f and the eighth side surface 221h are disposed to face corners of an outer side surface 223 of the sidewall 221 most adjacent thereto, respectively.

Referring to FIG. 2a, the first inner side surface 221a, the third inner side surface 221c, the fifth inner side surface 221e, and the seventh side surface 221g may have the same length as or a greater length than the second inner side surface 221b, the fourth inner side surface 221d, the sixth side surface 221f, and the eighth side surface 221e.

If the second inner side surface 221b, the fourth inner side surface 221d, the sixth side surface 221f, and the eighth side surface 221e are longer than the first inner side surface 221a, the third inner side surface 221c, the fifth inner side surface 221e, and the seventh side surface 221g, the cavity 229 can have a narrower area. As a result, it can be difficult to secure a sufficient area for mounting a light emitting diode chip 230 and a protective element 290.

Among the first to eight inner side surfaces 221a, 221b, 221c, 221d, 221e, 221f, 221g, 221h, adjacent inner side surfaces may be connected to each other. Here, the adjacent inner side surfaces 221 may be disposed to form an angle of 90 degrees or more therebetween. If the inner side surfaces 221 are disposed to form an angle of less than 90 degrees between the adjacent inner side surfaces 221, there can be a problem of failing to secure a sufficient area of the cavity 229 for mounting the light emitting diode chip 230 and the protective element 290 therein. If the adjacent inner side surfaces 221 are disposed to form an angle of 90 degrees therebetween, there can be a problem of high possibility of detachment of the lens 250 due to deterioration in adhesion to the lens 250 through reduction in area of the upper surface of the sidewall, despite formation of the cavity 229 having a sufficient area.

Referring to FIG. 2a, the upper surface 227 of the sidewall 220 may include a first region B1 connected to the first inner side surface 221a, a second region B2 connected to the second inner side surface 221b, a third region B3 connected to the third inner side surface 221c, a fourth region B4 connected to the fourth inner side surface 221d, a fifth region B5 connected to the fifth inner side surface 221e, a sixth region B6 connected to the sixth inner side surface 221f, a seventh region B7 connected to the seventh inner side surface 221g, and an eighth region B8 connected to the eighth inner side surface 221h. A border line between two adjacent regions among the first to eighth regions B1, B2, B3, B4, B5, B6, B7, B8 may be the shortest straight line between a corner of each of the inner side surfaces 221 of the sidewall 220 and the outer side surface 223 of the sidewall 220.

The first region B1, the third region B2, the fifth region B5, and the seventh region B7 may have the same area. In addition, the second region B2, the fourth region B3, the sixth region 4, and the eighth region B8 may have the same area. Further, each of the first region B1, the third region B2, the fifth region B5, and the seventh region B7 may have a smaller region than each of the second region B2, the fourth region B3, the sixth region 4, and the eighth region B8.

Accordingly, in each of the second region B2, the fourth region B3, the sixth region 4, and the eighth region B8, a bonding layer 270 may have a larger area than in each of the first region B1, the third region B2, the fifth region B5, and the seventh region B7. Accordingly, the bonding layer 270 formed in the second region B2, the fourth region B3, the sixth region 4, and the eighth region B8 may be uniformly formed in a larger area than the bonding layer formed in other regions.

Straight distances between the first inner side surface 221a and the fifth inner side surface 221e and between the third inner side surface 221c and the seventh side surface 221g at the center of the cavity 229 may be in the range of 2.5 mm to 2.8 mm, specifically 2.64 mm.

The cavity 229 may have a sufficient size to mount the light emitting diode chip 230 and the protective element 290 therein.

Further, the cavity 229 may have a sufficient size such that the light emitting diode chip 230 and the protective element 270 can be connected to first, second and third wires W1, W2, W3 without interference.

In the light emitting diode package 2000 according to this embodiment, the light emitting diode chip 230 is connected to the first interconnect pattern 211 by wire bonding, without being limited thereto.

The light emitting diode chip 230 and the protective element 290 may have a flip-chip type structure. In this structure, as shown in FIG. 2c, the light emitting diode chip 230 may be mounted on interconnect patterns by a flip-chip bonding method.

Referring to FIG. 2c, the light emitting diode chip 230 and the protective element 290 may be mounted both on a first interconnect pattern 211 and a second interconnect pattern 213 spaced apart from each other.

The first interconnect pattern 211 may be symmetrical to the second interconnect pattern 213 with reference to an insulating region 215. In addition, the first interconnect pattern 211 and the second interconnect pattern 213 may be formed such that the insulating region 215 has a straight line shape extending from one side of the cavity 229 to the other side thereof.

That is, one electrode of the light emitting diode chip 230 and one electrode of the protective element 290 may be disposed on the first interconnect pattern 211 to be electrically connected to the first interconnect pattern 211. In addition, the other electrode of the light emitting diode chip 230 and the other electrode of the protective element 290 may be disposed on the second interconnect pattern 213 to be electrically connected to the second interconnect pattern 213.

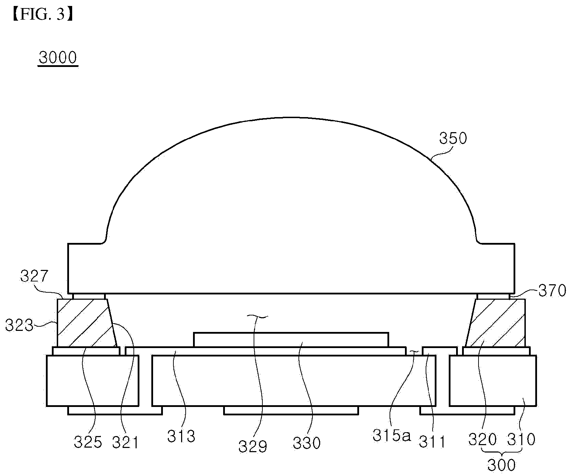

FIG. 3 is an exemplary view of a light emitting diode package according to a third embodiment of the present disclosure.

FIG. 3 is a cross-sectional view of the light emitting diode package 3000 according to the third embodiment.

Referring to FIG. 3, an inner side surface 321 of a sidewall 320 is inclined at an acute angle with respect to an upper surface of a substrate 310. Accordingly, the sidewall 320 has a structure in which the width of the sidewall 320 gradually decreases from the bottom to the top. Thus, the cavity 329 has a structure in which the width of the cavity 329 gradually increases from the bottom to the top.

As such, the inclined side surface 321 of the sidewall 320 can improve light extraction efficiency of the light emitting diode package 3000 by diffusely reflecting light emitted from the light emitting diode chip 330. In addition, the light emitting diode package 3000 may further include a reflective material coated on the inner side surface 321 of the sidewall 320 to further improve light extraction efficiency.

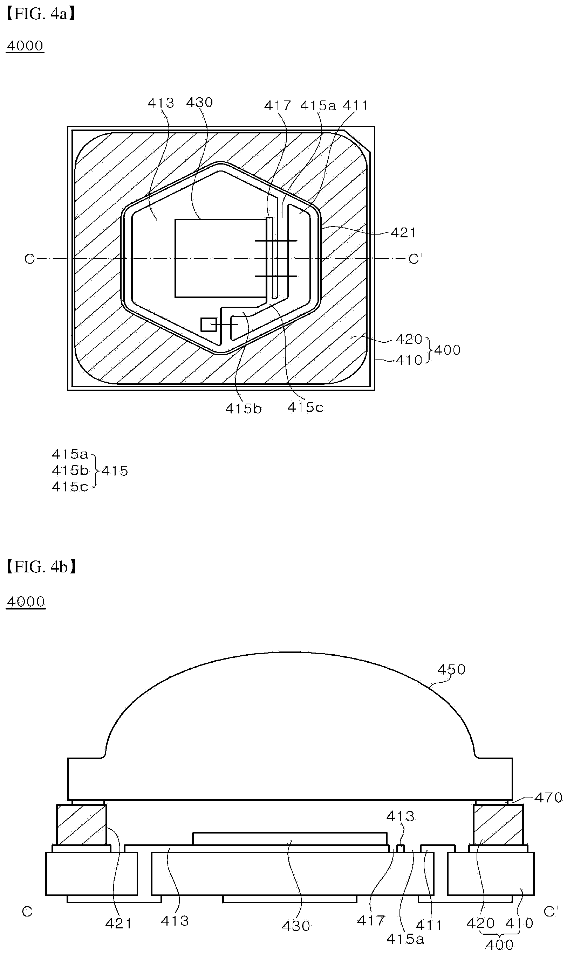

FIG. 4 is exemplary views of a light emitting diode package according to a fourth embodiment of the present disclosure.

FIG. 4a is a plan view of a light emitting diode package according to the fourth embodiment of the present disclosure. FIG. 4b is a cross-sectional view (C-C') of the light emitting diode package according to the fourth embodiment of the present disclosure.

The light emitting diode package 4000 according to this embodiment may further include a groove 416 on a second interconnect pattern 413.

Referring to FIG. 4a and FIG. 4b, the groove 417 may be formed inside the second interconnect pattern 413 to be parallel to a first insulating region 415a. That is, the groove 417 may extend from one side of the second interconnect pattern 413 in an inward direction. Accordingly, the groove 417 is closed at one end thereof by the second interconnect pattern 413 and is open at the other end thereof. The open other end of the groove 417 may be connected to a third insulating region 415c. Here, a light emitting diode chip 430 may be disposed adjacent to one side of the second interconnect pattern 413 exposed through the groove 417.

Further, the groove 417 may have a greater length than one side of the light emitting diode chip 430. Here, the one side of the light emitting diode chip 430 is parallel to the groove 417.

A sidewall 420 of the light emitting diode package 4000 according to this embodiment may have the same structure as the sidewall 121 (see FIG. 1) of the light emitting diode package according to the first embodiment.

Referring to FIG. 4b, the groove 417 may have a constant width from the top to the bottom.

A bonding agent interposed between the light emitting diode chip 430 and the second interconnect pattern 413 can be melted by heat from the light emitting diode chip 430 to flow thereon. When the bonding agent flows along the surface of the second interconnect pattern 413 and contacts the surface of the first interconnect pattern 411, electric short can occur on the first interconnect pattern 411 and the second interconnect pattern 413.

However, the light emitting diode package 4000 according to this embodiment allows the bonding agent to flow into the groove 417 on the second interconnect pattern 413 when the bonding agent flows towards the first interconnect pattern 411. Here, side surfaces of the second interconnect pattern 413 defining the groove 417 can act as a dam that traps the bonding agent in the groove 417.

As such, the light emitting diode package 4000 according to this embodiment includes the groove 417 on the second interconnect pattern 413, thereby preventing electric short on the first interconnect pattern 411 and the second interconnect pattern 413 due to flow of the bonding agent.

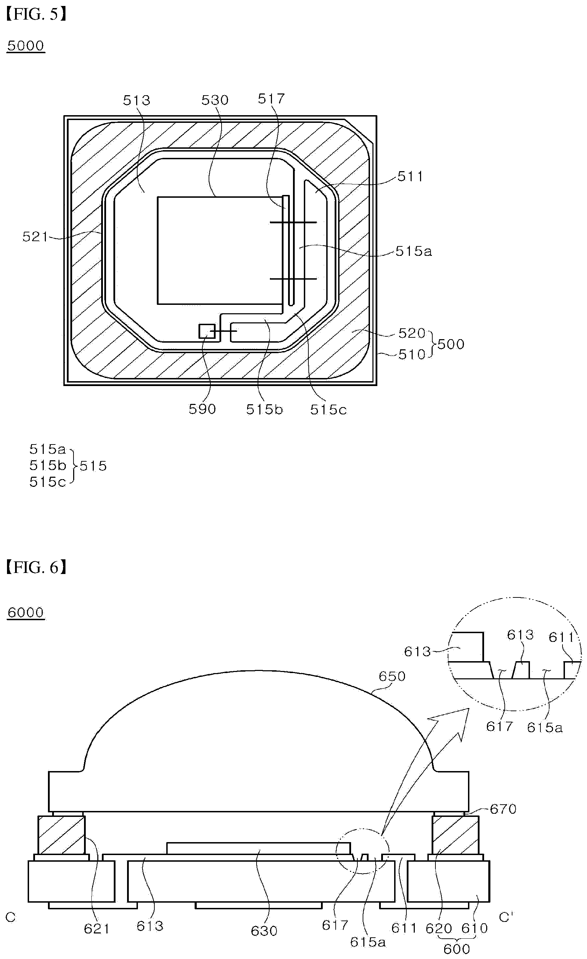

FIG. 5 is an exemplary view of a light emitting diode package according to a fifth embodiment of the present disclosure.

In the light emitting diode package 5000 according to the fifth embodiment, a groove 517 is formed on a second interconnect pattern 513 as in the fourth embodiment.

However, the light emitting diode package 5000 according to the fifth embodiment includes a sidewall 520 having a different structure than that of the light emitting diode package 4000 (see FIG. 4) according to the fourth embodiment.

FIG. 6 is exemplary views of a light emitting diode package according to a sixth embodiment of the present disclosure.

In the light emitting diode package 6000 according to the sixth embodiment, a groove 617 is formed on a second interconnect pattern 613 as in the above embodiments.

For a plan view of the light emitting diode package according to the sixth embodiment, refer to FIG. 4a. That is, FIG. 6 is a cross-sectional view taken at the same location as the cross-sectional view of FIG. 4b.

According to this embodiment, the groove 617 has different widths at the top and at the bottom. For example, the groove 617 may have a greater width at the top than at the bottom, as shown in FIG. 6. A second interconnect pattern 613 surrounding the groove 617 has inclinations at both sides thereof, whereby the groove 617 can have the same structure as the structure shown in FIG. 6.

Although the second interconnect pattern 613 surrounding the groove 617 has inclinations at both sides thereof in this embodiment, the second interconnect pattern may have an inclination at one side thereof.

In addition, although the groove 617 has a greater with at the upper portion thereof than at the lower portion thereof in this embodiment, the groove 617 may have a greater with at the lower portion thereof than at the upper portion thereof.

For the light emitting diode package 6000 according to this embodiment, the sidewall 621 may have the same structure as any one of the sidewalls according to the above embodiments.

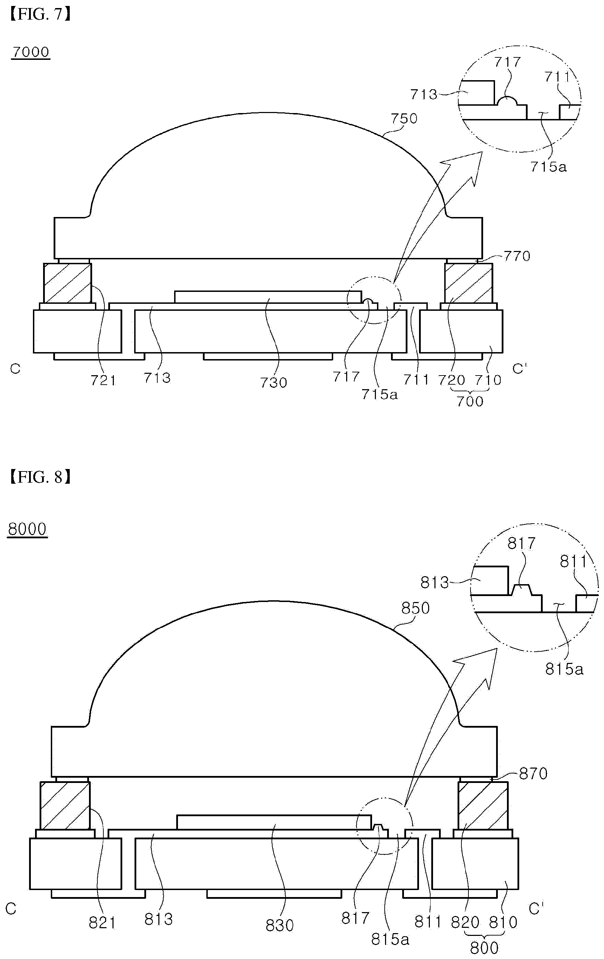

FIG. 7 is an exemplary view of a light emitting diode package according to a seventh embodiment of the present disclosure.

The light emitting diode package 7000 according to the seventh embodiment may include a dam 717 on a second interconnect pattern 713.

In the above embodiments, the groove is formed on the second interconnect pattern, whereas the dam 717 is formed thereon instead of the groove in this embodiment. That is, in this embodiment, the dam 717 may be formed at the same location as the groove in the above embodiments.

For a plan view of the light emitting diode package according to the seventh embodiment, refer to FIG. 4a. That is, FIG. 7 is a cross-sectional view taken at the same location as the cross-sectional view of FIG. 4b.

Specifically, the dam 717 is formed parallel to a first insulating region 715a and has one end disposed inside one side of the second interconnect pattern 713. In addition, the other end of the dam 717 may be placed on the same vertical line as the other side of the second interconnect pattern 713 that forms a third insulating region 715c.

The dam 717 may protrude from an upper surface of the second interconnect pattern 713. The dam 717 may have a lower height than a light emitting diode chip 730. Thus, an upper surface of the dam 717 is placed above the upper surface of the second interconnect pattern 713. In addition, the upper surface of the dam 717 is placed below the upper surface of the light emitting diode chip 730.

Thus, according to this embodiment, the dam 717 can prevent the bonding agent interposed between the light emitting diode chip 730 and the second interconnect pattern 713 from flowing towards the first interconnect pattern 711.

Referring to FIG. 7, the dam 717 may have a convex semi-spherical shape.

In addition, according to this embodiment, the dam 717 may be formed of the same material as the second interconnect pattern 713.

FIG. 8 is an exemplary view of a light emitting diode package according to an eighth embodiment of the present disclosure.

The light emitting diode package 8000 according to the eighth embodiment may a dam 817 on a second interconnect pattern 813.

For a plan view of the light emitting diode package according to the eighth embodiment, refer to FIG. 4a. That is, FIG. 8 is a cross-sectional view taken at the same location as the cross-sectional view of FIG. 4b.

According to this embodiment, a dam 817 may have inclined side surfaces. Referring to FIG. 8, the dam 817 may have a structure in which the width of the dam 817 gradually increases from the top to the bottom. However, it should be understood that the structure of the dam 817 is not limited thereto. The dam 817 may have a structure in which only one side of the dam 817 is inclined. Alternatively, the dam 817 may have a structure in which the width of the dam 817 gradually decreases from the top to the bottom. In addition, the dam 817 may have a structure in which one side of the dam 817 is perpendicular to an upper surface of a second interconnect pattern 813 such that the dam 817 has a constant width from the top to the bottom.

All of the groove 417 and the dam 417 described with reference to FIG. 4 to FIG. 8 act as short preventing portions that prevent occurrence of short due to the bonding agent between the light emitting diode chip and the interconnect pattern.

The groove 417 and the dam 417 described with reference to FIG. 4 to FIG. 8 may be formed separately after formation of the second interconnect pattern on the substrate. Alternatively, the groove and the dam may be formed together with the second interconnect pattern upon formation of the second interconnect pattern on the substrate.

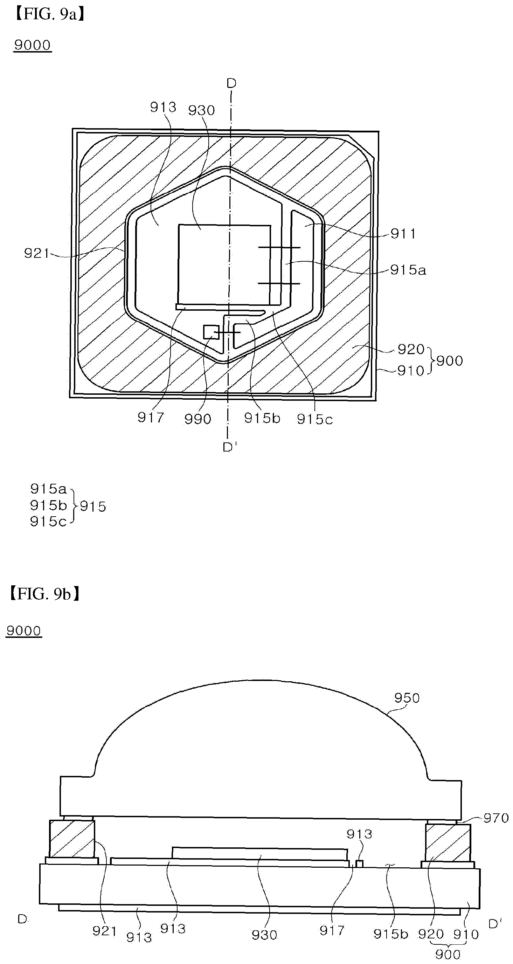

FIG. 9 is exemplary views of a light emitting diode package according to a ninth embodiment of the present disclosure.

FIG. 9a is a plan view of a light emitting diode package according to the ninth embodiment of the present disclosure. FIG. 9b is a cross-sectional view (D-D') of the light emitting diode package according to the ninth embodiment of the present disclosure.

The light emitting diode package 9000 according to this embodiment may further include a groove 917 on a second interconnect pattern 913.

Referring to FIG. 9a, the groove 917 extends inside the second interconnect pattern 913 and may be disposed parallel to a second insulating region 915b. That is, the groove 917 may be disposed between a light emitting diode chip 930 and a protective element 990.

The groove 917 is closed at one end thereof by the second interconnect pattern 913 and is open at the other end thereof. The open other end of the groove 917 may be connected to a third insulating region 915c.

In this embodiment, the light emitting diode chip 930 may be disposed such that one side of the light emitting diode chip 930 is adjacent to one side of the second interconnect pattern 913 exposed through the groove 917.

Further, the groove 917 may have a greater length than one side of the light emitting diode chip 930. Here, the one side of the light emitting diode chip 930 is parallel to the groove 917.

The light emitting diode package 9000 according to this embodiment may include a sidewall 920 including six inner side surfaces 921 as in the embodiments described above.

Referring to FIG. 9b, the groove 917 may have a constant width from the top to the bottom. However, it should be understood that the structure of the groove 917 is not limited thereto. Alternatively, the groove 917 may have different widths at the top and at the bottom.

With this structure, the groove 917 can prevent the bonding agent interposed between the light emitting diode chip 930 and the second interconnect pattern 913 from contacting the protective element 990 on a first interconnect pattern 911 or the second interconnect pattern 913.

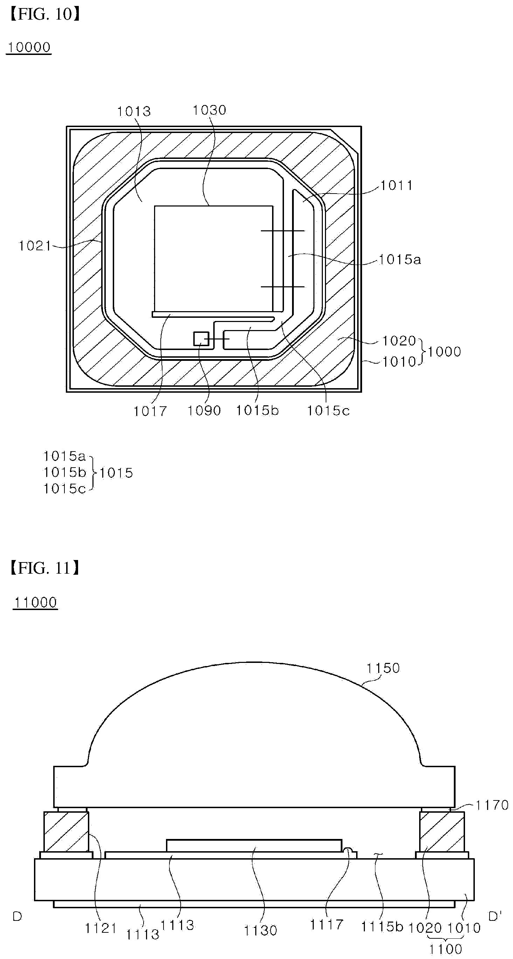

FIG. 10 is an exemplary view of a light emitting diode package according to a tenth embodiment of the present disclosure.

Referring to FIG. 10, the light emitting diode package 10000 according to the tenth embodiment has the same structure as the light emitting diode package 9000 (see FIG. 9) according to the ninth embodiment excluding a sidewall 1021.

The sidewall 1021 of the light emitting diode package 10000 according to this embodiment includes eight inner side surfaces 1021.

FIG. 11 is an exemplary view of a light emitting diode package according to an eleventh embodiment of the present disclosure.

The light emitting diode package 11000 according to the eleventh embodiment may include a dam 1117 on a second interconnect pattern 1113.

The dam 1117 may be formed at the same location as the groove 917 of the light emitting diode package 9000 (see FIG. 9) according to the ninth embodiment.

For a plan view of the light emitting diode package according to the ninth embodiment, refer to FIG. 9a. That is, FIG. 11 is a cross-sectional view taken at the same location as the cross-sectional view of FIG. 9b.

The dam 1117 is formed parallel to a second insulating region 1115b and may have one end disposed inside one side of the second interconnect pattern 1113. In addition, the other end of the dam 1117 may be placed on the same vertical line as the other side of the second interconnect pattern 1113 that forms a third insulating region 1115c.

Referring to FIG. 11, the dam 1117 may protrude upwards from an upper surface of the second interconnect pattern 1113. Here, the dam 1117 may have a lower height than a light emitting diode chip 1130. Accordingly, an upper surface of the dam 1117 is placed above the upper surface of the second interconnect pattern 1113. In addition, the upper surface of the dam 1117 is placed below an upper surface of the light emitting diode chip 1130.

Referring to FIG. 11, the dam 1117 has a semi-spherical shape. However, it should be understood that the structure of the dam 1117 is not limited thereto. That is, the dam 1117 may have any structure capable of preventing the bonding agent interposed between the light emitting diode chip 1130 and the second interconnect pattern 1113 from flowing to the protective element (not shown) mounted on the first interconnect pattern (not shown) or the second interconnect pattern 1113.

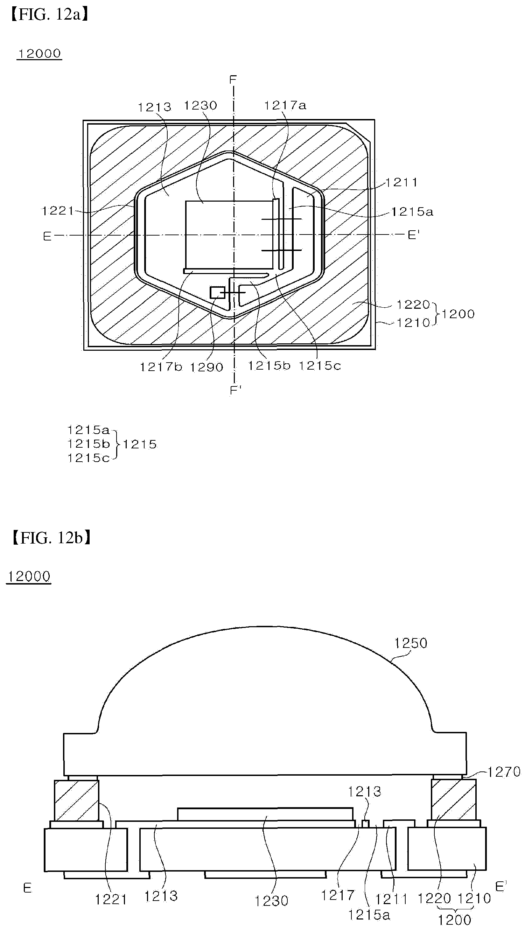

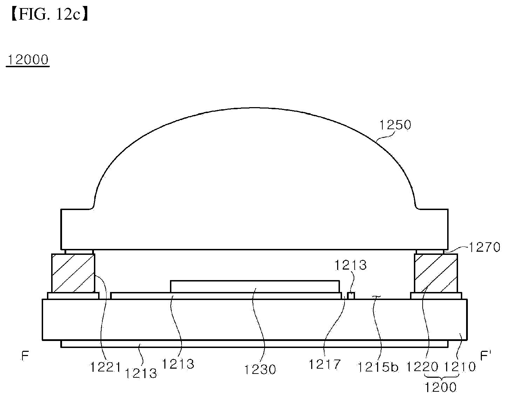

FIG. 12 is exemplary views of a light emitting diode package according to a twelfth embodiment of the present disclosure.

FIG. 12a is a plan view of the light emitting diode package according to the twelfth embodiment of the present disclosure. FIG. 12b is a cross-sectional view (E-E') of the light emitting diode package according to the twelfth embodiment of the present disclosure. FIG. 12c is another cross-sectional view (F-F') of the light emitting diode package according to the twelfth embodiment of the present disclosure.

The light emitting diode package 12000 includes a first groove 1217a and a second groove 1217b on a second interconnect pattern 1213.

Both the first groove 1217a and the second groove 1217b extend inside the second interconnect pattern 1213.

The first groove 1217a is formed parallel to a first insulating region 1215a and the second groove 1217b is formed parallel to a second insulating region 1215b. Each of the first groove 1217a and the second groove 1217b is closed at one end thereof by the second interconnect pattern 1213 and is open at the other end thereof. Here, both the open other end of the first groove 1217a and the open other end of the second groove 1217b are connected to a third insulating region 1215c.

The light emitting diode chip 1230 may be disposed such that one side of the light emitting diode chip 1230 parallel to the first insulating region 1215a is placed adjacent to one side of the second interconnect pattern 1213 exposed through the first groove 1217a. In addition, the other side of the light emitting diode chip 1230 parallel to the second insulating region 1215b may be placed adjacent to another side of the second interconnect pattern 1213 exposed through the second groove 1217b.

Each of the first groove 1217a and the second groove 1217b may have a greater length than the corresponding side surface of the light emitting diode chip 1230 parallel thereto.

The light emitting diode package 12000 according to this embodiment may include a sidewall 1220 including six inner side surfaces 1221 as in the embodiments described above.

Referring to FIG. 12b, the first groove 1217a may have a constant width from the top to the bottom. In addition, referring to FIG. 12c, the second groove 1217b may also have a constant width from the top to the bottom.

However, it should be understood that the structures of the first groove 1217a and the second groove 1217b are not limited thereto. Alternatively, each of the first groove 1217a and the second groove 1217b may have different widths at the top and at the bottom. In addition, the first groove 1217a and the second groove 1217b may have different structures from each other.

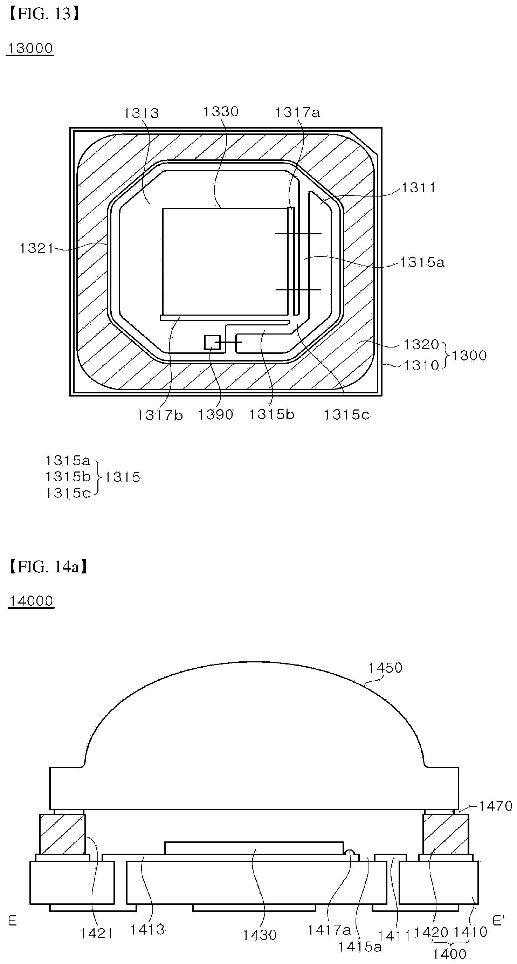

FIG. 13 is an exemplary view of a light emitting diode package according to a thirteenth embodiment of the present disclosure.

Referring to FIG. 13, the light emitting diode package 13000 according to the thirteenth embodiment may include a sidewall 1321 having a different structure than that of the light emitting diode package 12000 (see FIG. 12) according to the twelfth embodiment.

Specifically, the light emitting diode package 13000 according to the thirteenth embodiment includes a first groove 1317a and a second groove 1317b on a second interconnect pattern 1313, and the sidewall 1320 including eight inner side surfaces 1321.

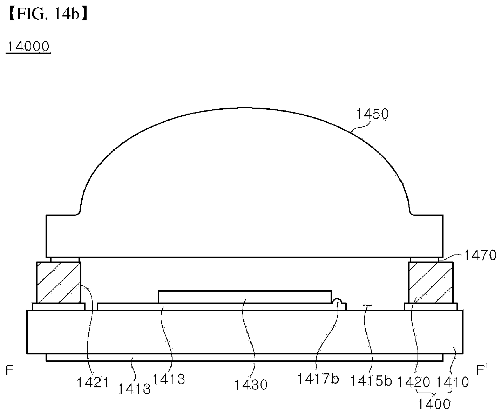

FIG. 14 is exemplary views of a light emitting diode package according to a fourteenth embodiment of the present disclosure.

FIG. 14a is a cross-sectional view of the light emitting diode package according to the fourteenth embodiment of the present disclosure. In addition, FIG. 14b is another cross-sectional view of the light emitting diode package according to the fourteenth embodiment of the present disclosure.

The light emitting diode package 14000 according to this embodiment has the same structure as the light emitting diode package 13000 (see FIG. 13) according to the twelfth and thirteenth embodiments excluding a first dam 1417a and a second dam 1417b, which are formed instead of the first groove 1317a and the second groove 1317b.

For a plan view of the light emitting diode package according to the fourteenth embodiment, refer to FIG. 12a. That is, FIG. 14a is a cross-sectional view taken at the same location as the cross-sectional view of FIG. 12b and FIG. 14b is a cross-sectional view taken at the same location as the cross-sectional view of FIG. 12c.

The light emitting diode package 14000 according to this embodiment includes the first dam 1417a and the second dam 1417b on a second interconnect pattern 1413.

Both the first dam 1417a and the second dam 1417b extend inside the second interconnect pattern 1413.

The first dam 1417a is formed parallel to a first insulating region 1415a and the second dam 1417b is formed parallel to a second insulating region 1415b. In addition, both the first dam 1417a and the second dam 1417b may protrude upwards from an upper surface of the second interconnect pattern 1413.

The first dam 1417a and the second dam 1417b may have lower heights than a light emitting diode chip 1430. Accordingly, an upper surface of each of the first dam 1417a and the second dam 1417b is placed above the upper surface of the second interconnect pattern 1413. In addition, the upper surface of each of the first dam 1417a and the second dam 1417b is placed below the upper surface of the light emitting diode chip 1430.

Referring to FIG. 14a and FIG. 14b, the first dam 1417a and the second dam 1417b have a semi-spherical shape. However, it should be understood that the structures of the first dam 1417a and the second dam 1417b are not limited thereto. The first dam 1417a and the second dam 1417b may have any structure capable of preventing the bonding agent interposed between the light emitting diode chip 1430 and the second interconnect pattern 1413 from flowing to the first interconnect pattern 1411.

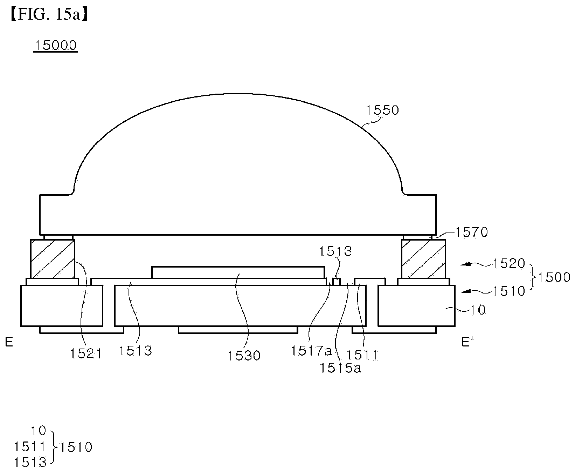

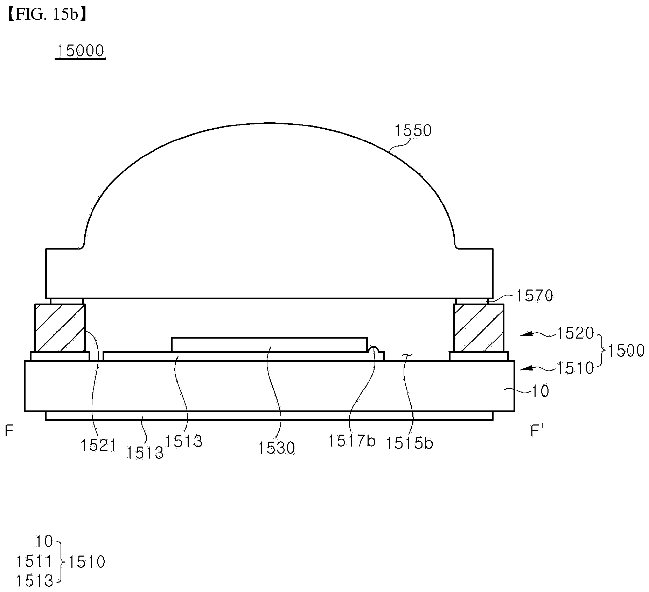

FIG. 15 is exemplary views of a light emitting diode package according to a fifteenth embodiment of the present disclosure.

FIG. 15a is a cross-sectional view of the light emitting diode package according to the fifteenth embodiment of the present disclosure. In addition, FIG. 15b is another cross-sectional view of the light emitting diode package according to the fifteenth embodiment of the present disclosure.

The light emitting diode package 15000 according to this embodiment has the same structure as the light emitting diode package according to the twelfth and thirteenth embodiments excluding a dam 1517, which is formed instead of the second dam.

For a plan view of the light emitting diode package 15000 according to the fifteenth embodiment, refer to FIG. 12a. That is, FIG. 15a is a cross-sectional view taken at the same location as the cross-sectional view of FIG. 12b and FIG. 15b is a cross-sectional view taken at the same location as the cross-sectional view of FIG. 12c.

The light emitting diode package 15000 according to this embodiment includes a groove 1517 and a dam 1517 on a second interconnect pattern 1513.

Both the groove 1517 and the dam 1517 may extend inside the second interconnect pattern 1513.

The groove 1517 is formed parallel to a first insulating region 1515a and the dam 1517 is formed parallel to a second insulating region 1515b. In addition, the groove 1517 is concavely formed on an upper surface of the second interconnect pattern 1513 to expose the upper surface of the base 10 of the substrate 1510. In addition, the dam 1517 may protrude upwards from the upper surface of the second interconnect pattern 1513.

Referring to FIG. 15a, the groove 1517 may have a constant width from the top to the bottom. However, it should be understood that the structure of the groove 1517 is not limited thereto. The groove 1517 may have different widths at the top and at the bottom.

Referring to FIG. 15b, the dam 1517 may have a semi-spherical structure in which the dam 1517 has a lower height than a light emitting diode chip 1530. Accordingly, an upper surface of the dam 1517 is placed above the upper surface of the second interconnect pattern 1513. In addition, the upper surface of the dam 1517 is placed below an upper surface of the light emitting diode chip 1530.

However, it should be understood that the structures of the groove 1517 and the dam 1517 are not limited thereto. Alternatively, the groove 1517 and the dam 1517 may have any structure capable of preventing the bonding agent interposed between the light emitting diode chip 1530 and the second interconnect pattern 1513 from flowing to the first interconnect pattern 1511.

According to this embodiment, the locations of the groove 1517 and the dam 1517 may be changed. That is, the groove 1517 may be formed parallel to the second insulating region 1515b and the dam 1517 may be formed parallel to first insulating region 1515a.

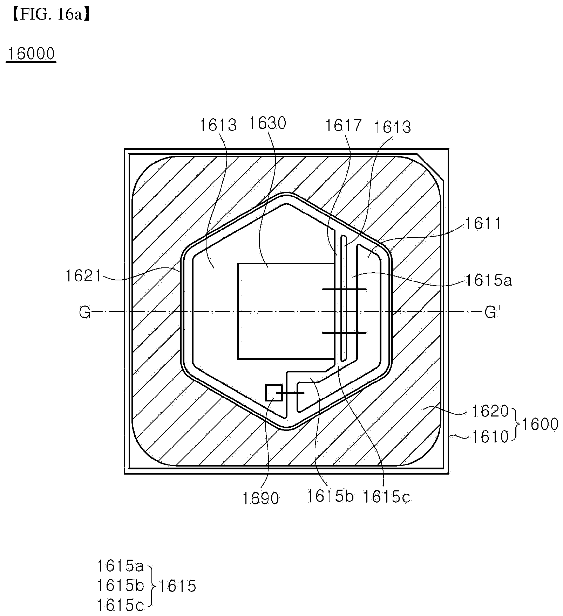

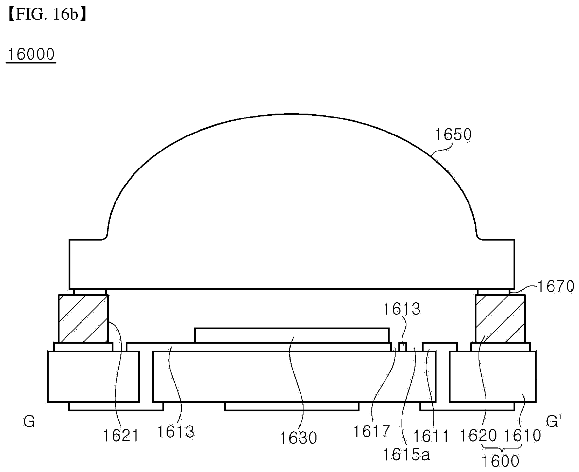

FIG. 16 is exemplary views of a light emitting diode package according to a sixteenth embodiment of the present disclosure.

FIG. 16a is a plan view of the light emitting diode package according to the sixteenth embodiment of the present disclosure. FIG. 16b is a cross-sectional view (G-G') of the light emitting diode package according to the sixteenth embodiment of the present disclosure.

The light emitting diode package 16000 according to this embodiment includes a groove 1617 formed on a second interconnect pattern 1613 to be parallel to a first insulating region 1615a.

Referring to FIG. 16a, the groove 1617 may extend from a third insulating region 1615c to be parallel to the first insulating region 1615a. Here, the groove 1617 may have a greater length than the first insulating region 1615a.

In addition, the groove 1617 is formed inside the second interconnect pattern 1613 and has a structure in which the groove 1617 penetrates from one side of the second interconnect pattern 1613 to the other side thereof. That is, according to this embodiment, the groove 1617 is open at opposite ends thereof.

Accordingly, the light emitting diode package 16000 according to this embodiment has a structure in which the second interconnect pattern 1613 is partially divided between the groove 1617 and the first insulating region 1615a.

Referring to FIG. 16b, the groove 1617 may have a constant width from the top to the bottom. However, it should be understood that the structure of the groove 1617 is not limited thereto. Alternatively, the groove 1617 may have different widths at the top and at the bottom.

The light emitting diode package 16000 according to this embodiment may include a sidewall 1620 including six inner side surfaces 1621.

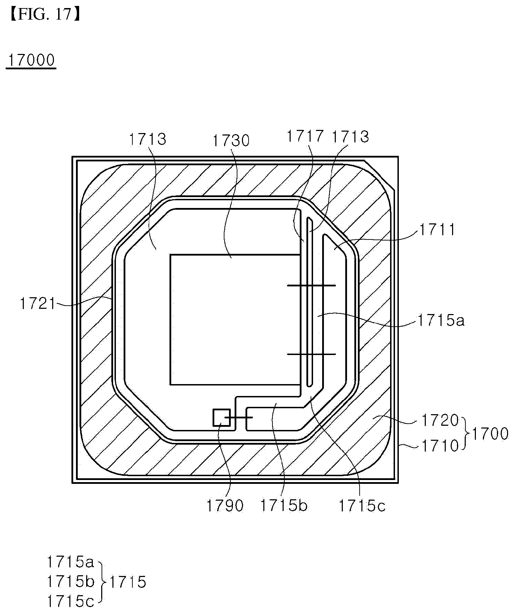

FIG. 17 is an exemplary view of a light emitting diode package according to a seventeenth embodiment of the present disclosure.

Referring to FIG. 17, the light emitting diode package 17000 according to the seventeenth embodiment may include a sidewall 1720 having a different structure than that of the light emitting diode package 16000 (see FIG. 16) according to the sixteenth embodiment.

Specifically, the light emitting diode package 17000 according to the seventeenth embodiment includes a groove 1717 formed on a second interconnect pattern 113 and open at opposite ends thereof, and the sidewall 1720 includes eight inner side surfaces 1721.

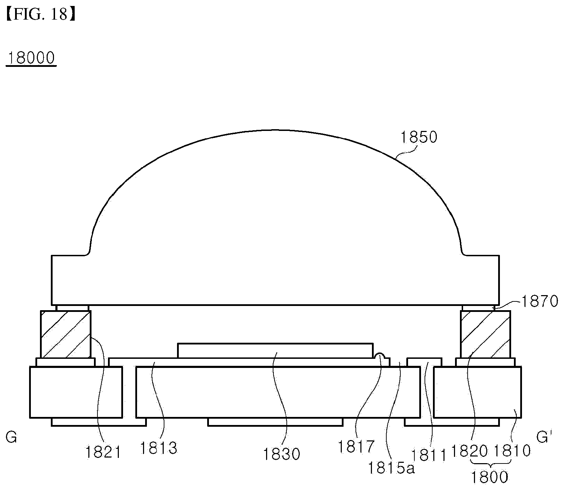

FIG. 18 is an exemplary view of a light emitting diode package according to an eighteenth embodiment of the present disclosure.

The light emitting diode package 18000 according to the eighteenth embodiment may include a dam 1817 on a second interconnect pattern 1813.

The dam 1817 may be formed at the same location as the groove 1817 of the light emitting diode package 16000 (see (FIG. 16a) according to the sixteenth embodiment.

For a plan view of the light emitting diode package according to the eighteenth embodiment, refer to FIG. 16a. That is, FIG. 18 is a cross-sectional view taken at the same location as the cross-sectional view of FIG. 16b.

In the above embodiments, one end of the dam is disposed inside one side of the second interconnect pattern. However, according to this embodiment, the dam 1817 has one end and the other end placed on the same vertical line as one side and the other side of the second interconnect pattern 1813. That is, the dam 1817 extends from one side of the first interconnect pattern 1813 to the other side thereof to be parallel to the first insulating region 1815a.

Referring to FIG. 18, the dam 1817 may protrude upwards from an upper surface of the second interconnect pattern 1813. Here, the dam 1817 may have a lower height than a light emitting diode chip 1830. Accordingly, an upper surface of the dam 1817 is placed above the upper surface of the second interconnect pattern 1813. In addition, the upper surface of the dam 1817 is placed below an upper surface of the light emitting diode chip 1830.

Referring to FIG. 18, the dam 1817 has a semi-spherical shape. However, it should be understood that the structure of the dam 1817 is not limited thereto. That is, the dam 1817 may have any structure capable of preventing the bonding agent interposed between the light emitting diode chip 1830 and the second interconnect pattern 1813 from flowing to a first interconnect pattern 1811.

A sidewall 1820 of the light emitting diode package 18000 according to this embodiment includes six or eight inner side surfaces as described above.

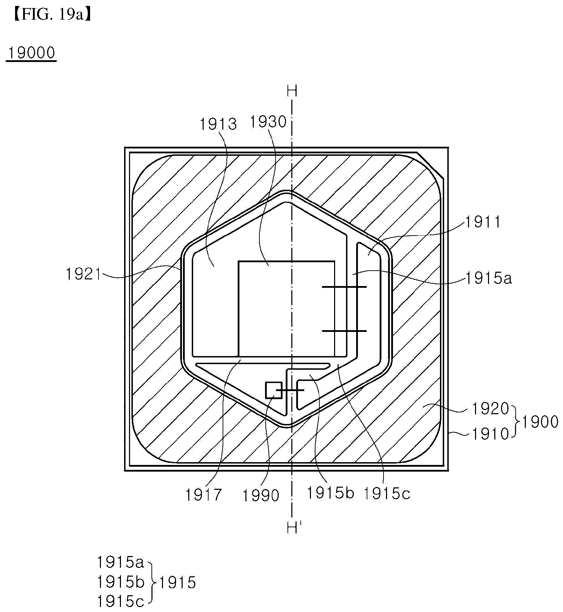

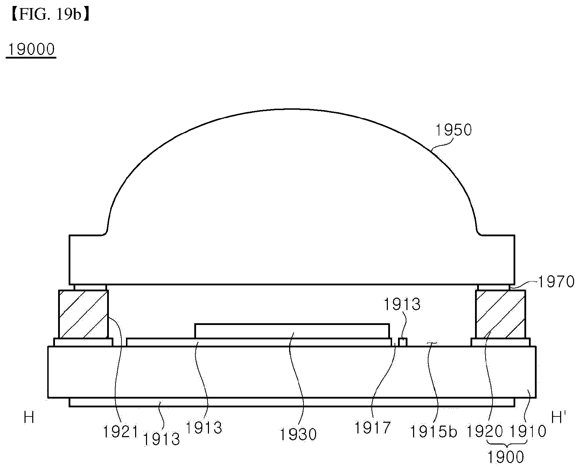

FIG. 19 is exemplary views of a light emitting diode package according to a nineteenth embodiment of the present disclosure.

FIG. 19a is a plan view of the light emitting diode package according to the nineteenth embodiment of the present disclosure. FIG. 16b is a cross-sectional view (H-H') of the light emitting diode package according to the nineteenth embodiment of the present disclosure.

The light emitting diode package 19000 according to this embodiment includes a groove 1917 formed on a second interconnect pattern 1913 to be parallel to a second insulating region 1915b.

Referring to FIG. 19a, the groove 1917 extends from a third insulating region 1915c to be parallel to the second insulating region 1915b. Here, the groove 1917 may have a greater length than the second insulating region 1915b.

In addition, the groove 1917 formed inside the second interconnect pattern 1913 has a structure in which the groove 1917 penetrates from one side of the second interconnect pattern 1913 to the other side thereof. That is, according to this embodiment, the groove 1917 is open at opposite ends thereof.

Accordingly, the light emitting diode package 19000 according to this embodiment has a structure in which the groove 1917 divides a portion of the second interconnect pattern 1913 on which a protective element 1990 is mounted from a portion of the second interconnect pattern 1913 on which a light emitting diode chip 1930 is mounted.

Referring to FIG. 19b, the groove 1917 may have a constant width from the top to the bottom. However, it should be understood that the structure of the groove 1917 is not limited thereto. Alternatively, the groove 1917 may have different widths at the top and at the bottom.

The light emitting diode package 19000 according to this embodiment may include a sidewall 1920 including six inner side surfaces 1921.

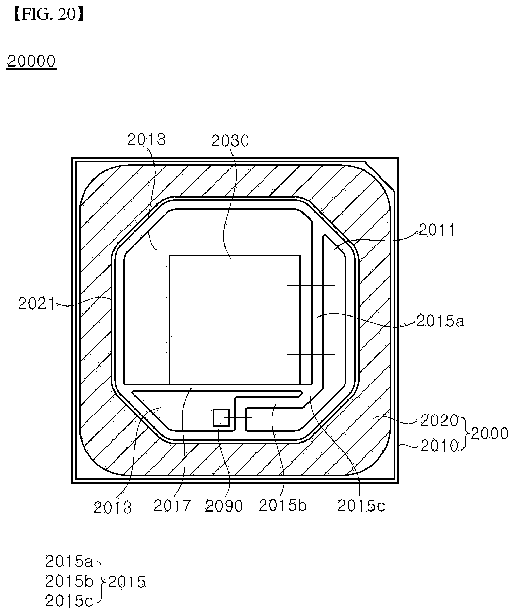

FIG. 20 is an exemplary view of a light emitting diode package according to a twentieth embodiment of the present disclosure.

Referring to FIG. 20, the light emitting diode package 20000 according to the twentieth embodiment includes a sidewall 2021 having a different structure from the side wall of the light emitting diode package 19000 (see FIG. 19) according to the nineteenth embodiment.

Specifically, the light emitting diode package 20000 according to the twentieth embodiment includes a groove 2017 formed on a second interconnect pattern 2013 and open at opposite ends thereof, and the sidewall 2020 including eight inner side surfaces 2021.

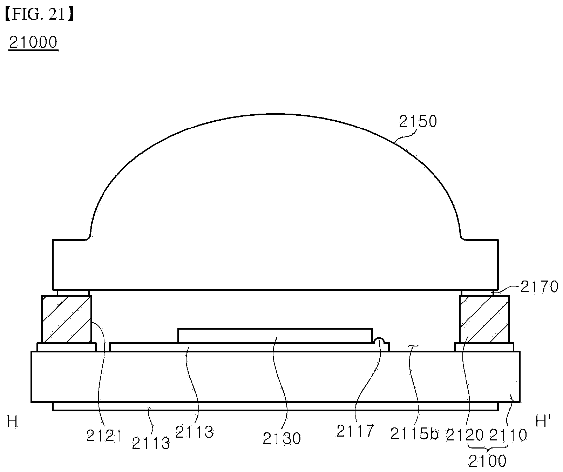

FIG. 21 is an exemplary view of a light emitting diode package according to a twenty first embodiment of the present disclosure.

The light emitting diode package 21000 according to the twenty first embodiment includes a dam 2117 formed on the second interconnect pattern 2113.

The dam 2117 may be formed at the same location as the groove 1917 of the light emitting diode package 19000 (see FIG. 19) according to the nineteenth embodiment.

For a plan view of the light emitting diode package light emitting diode package 21000 according to the twenty first embodiment, refer to FIG. 19a. That is, FIG. 21 is a cross-sectional view taken at the same location as the cross-sectional view of FIG. 16b.

In the above embodiments, one end of the dam is disposed inside one side of the second interconnect pattern. However, according to this embodiment, the dam 2117 has one end and the other end placed on the same vertical line as one side and the other side of the second interconnect pattern.

Referring to FIG. 21, the dam 2117 may protrude upwards from an upper surface of the second interconnect pattern 2113. Here, the dam 2117 may have a lower height than a light emitting diode chip 2130. Accordingly, an upper surface of the dam 2117 is placed above the upper surface of the second interconnect pattern 2113. In addition, the upper surface of the dam 2117 is placed below an upper surface of the light emitting diode chip 2130

Referring to FIG. 21, the dam 2117 has a semi-spherical shape. However, it should be understood that the structure of the dam 2117 is not limited thereto. The dam 2117 may have any structure capable of preventing the bonding agent interposed between the light emitting diode chip 2130 and the second interconnect pattern 2113 from flowing to a first interconnect pattern 2111.

A sidewall 2120 of the light emitting diode package 21000 according to this embodiment includes six or eight inner side surfaces as described above.

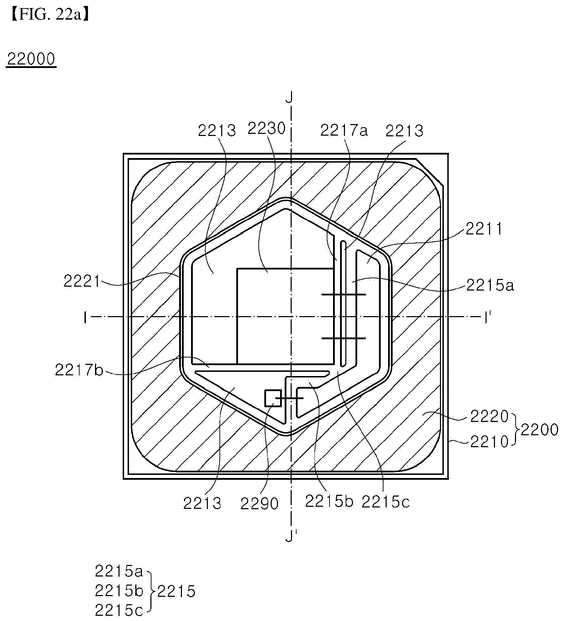

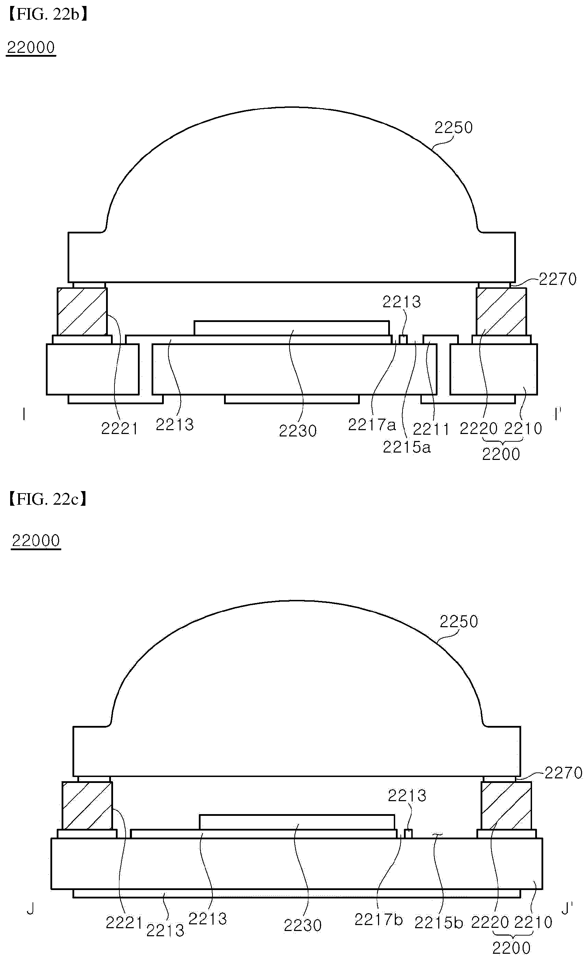

FIG. 22 is exemplary views of a light emitting diode package according to a twenty second embodiment of the present disclosure.

FIG. 22a is a plan view of the light emitting diode package according to the twenty second embodiment of the present disclosure. FIG. 22b is a cross-sectional view (I-I') of the light emitting diode package according to the twenty second embodiment of the present disclosure. FIG. 22c is another cross-sectional view (1-1') of the light emitting diode package according to the twenty second embodiment of the present disclosure.

The light emitting diode package 22000 according to this embodiment includes a first groove 2217a and a second groove 2217b on a second interconnect pattern 2213.

Both the first groove 2217a and the second groove 2217b extend inside the second interconnect pattern 2213.

The first groove 2217a is formed parallel to a first insulating region 2215a and the second groove 2217b is formed parallel to a second insulating region 2215b. Each of the first groove 2217a and the second groove 2217b is closed at one end thereof and is open at the other end thereof. Here, both the open other end of the first groove 2217a and the open other end of the second groove 2217b are connected to a third insulating region 2215c.

That is, the first groove 2217a may be formed through the second interconnect pattern 2213 to be parallel to the first insulating region 2215a. In addition, the second groove 2217b may be formed through the second interconnect pattern 2213 to be parallel to the second insulating region 2215b. Accordingly, the light emitting diode package 22000 may have a structure in which the second interconnect pattern 2213 is partially separated between the first insulating region 2215a and the first groove 2217a by the first groove 2217a. In addition, the light emitting diode package 20000 has a structure in which the second groove 2217b divides a portion of the second interconnect pattern 2213 on which a protective element 290 is mounted from a portion of the second interconnect pattern 2213 on which a light emitting diode chip 2230 is mounted.

The light emitting diode chip 2230 may be disposed such that one side of the light emitting diode chip 2230 parallel to the first insulating region 2215a is adjacent to one side of the second interconnect pattern 2213 exposed through the first groove 2217a. In addition, the other side of the light emitting diode chip 1230 parallel to the second insulating region 1215b may be disposed adjacent to another side of the second interconnect pattern 1213 exposed through the second groove 1217b.

Each of the first groove 2217a and the second groove 2217b may have a greater length than the corresponding side surface of the light emitting diode chip 2230 parallel thereto.

The light emitting diode package 22000 according to this embodiment may include a sidewall 2220 including six inner side surfaces 1221 as in the embodiments described above.

Referring to FIG. 22b, the first groove 2217a may have a constant width from the top to the bottom. In addition, referring to FIG. 22c, the second groove 2217b may also have a constant width from the top to the bottom.

However, it should be understood that the structures of the first groove 2217a and the second groove 2217b are not limited thereto. Alternatively, each of the first groove 2217a and the second groove 2217b may have different widths at the top and at the bottom. In addition, the first groove 2217a and the second groove 2217b may have different structures from each other.

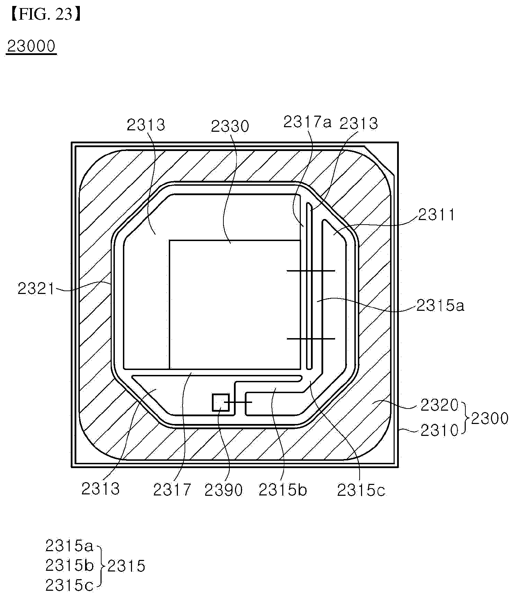

FIG. 23 is an exemplary view of a light emitting diode package according to a twenty third embodiment of the present disclosure.

Referring to FIG. 23, the light emitting diode package 23000 according to the twenty third embodiment may include a sidewall 2320 having a different structure than that of the light emitting diode package 22000 (see FIG. 22) according to the twenty second embodiment.

Specifically, the light emitting diode package 23000 according to the twenty third embodiment includes a first groove 2317a and a second groove 2317b on a second interconnect pattern 2313, and the sidewall 2320 including eight inner side surfaces 2321.

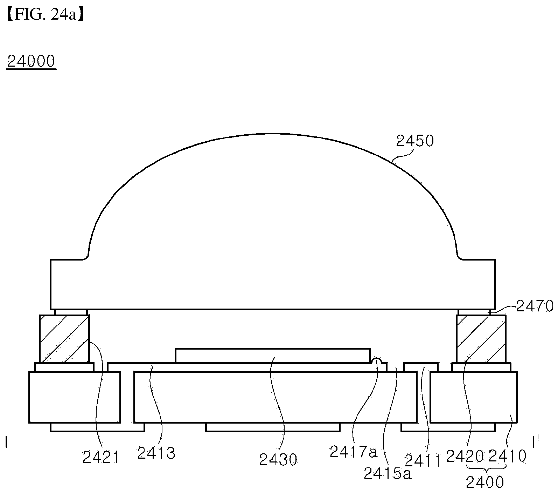

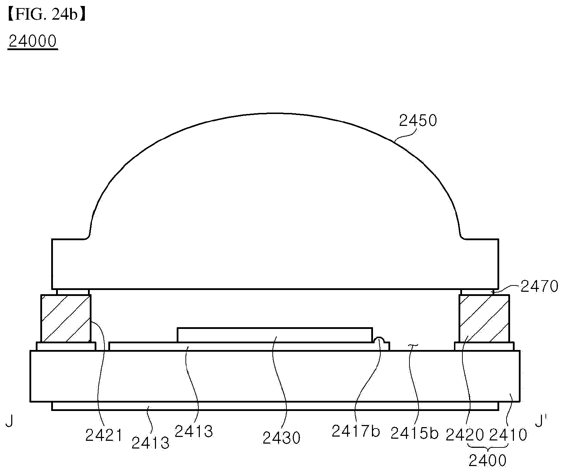

FIG. 24 is exemplary views of a light emitting diode package 24000 according to a twenty fourth embodiment of the present disclosure.

FIG. 24a is a cross-sectional view of the light emitting diode package according to the twenty fourth embodiment of the present disclosure. In addition, FIG. 24b is another cross-sectional view of the light emitting diode package according to the twenty fourth embodiment of the present disclosure.

The light emitting diode package 24000 according to this embodiment has the same structure as the light emitting diode package according to the twenty third embodiment excluding a first dam 2417a and a second dam 2417b, which are formed instead of the first groove and the second groove.

For a plan view of the light emitting diode package according to the twenty fourth embodiment, refer to FIG. 22. That is, FIG. 24a is a cross-sectional view taken at the same location as the cross-sectional view of FIG. 22b and FIG. 22b is a cross-sectional view taken at the same location as the cross-sectional view of FIG. 22c.

The light emitting diode package 24000 according to this embodiment includes the first dam 2417a and the second dam 2417b on a second interconnect pattern 2413.

Both the first dam 2417a and the second dam 2417b extend inside the second interconnect pattern 2413.

The first dam 2417a is formed parallel to a first insulating region 2415a and the second dam 2417b is formed parallel to a second insulating region 2415b. In addition, both the first dam 2417a and the second dam 2417b may protrude upwards from an upper surface of the second interconnect pattern 2413.

The first dam 2417a and the second dam 2417b may have lower heights than a light emitting diode chip 2430. Accordingly, an upper surface of each of the first dam 2417a and the second dam 2417b is placed above the upper surface of the second interconnect pattern 2413. In addition, the upper surface of each of the first dam 2417a and the second dam 2417b is placed below the upper surface of the light emitting diode chip 2430.

Referring to FIG. 24a and FIG. 24b, the first dam 2417a and the second dam 2417b have a semi-spherical shape. However, it should be understood that the structures of the first dam 2417a and the second dam 2417b are not limited thereto. The first dam 2417a and the second dam 2417b may have any structure capable of preventing the bonding agent interposed between the light emitting diode chip 2430 and the second interconnect pattern 2413 from flowing to the first interconnect pattern 2411.

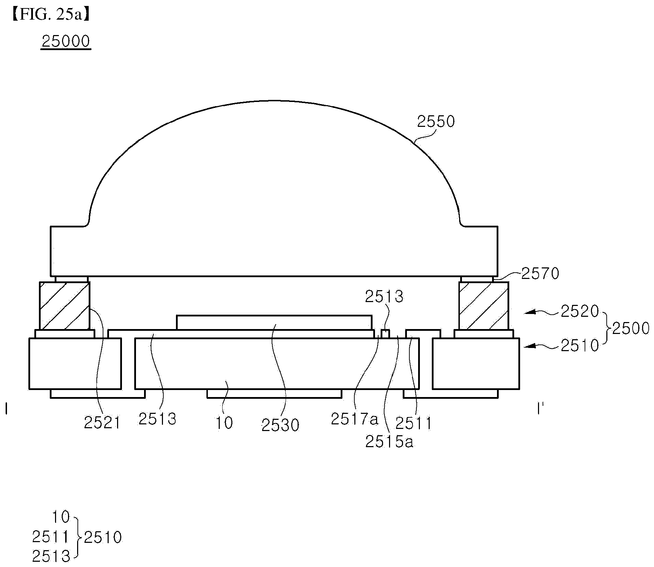

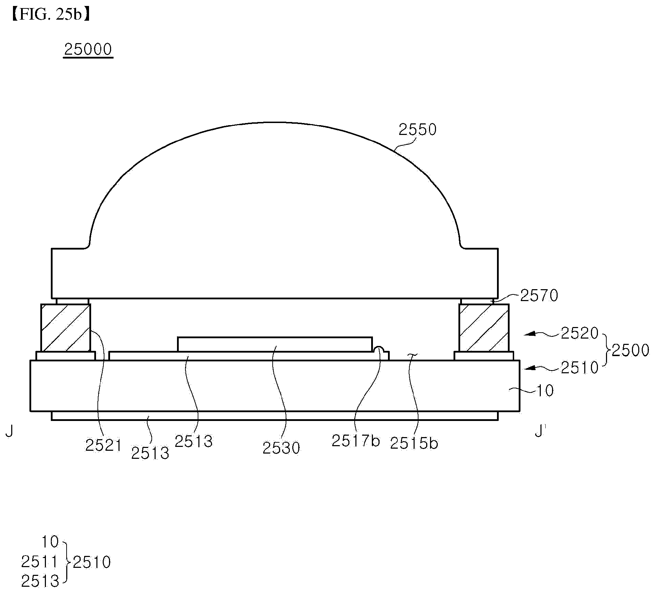

FIG. 25 is exemplary views of a light emitting diode package according to a twenty fifth embodiment of the present disclosure.

FIG. 25a is a cross-sectional view of the light emitting diode package according to the twenty fifth embodiment of the present disclosure. In addition, FIG. 15b is another cross-sectional view of the light emitting diode package according to the twenty fifth embodiment of the present disclosure.

The light emitting diode package 25000 according to this embodiment has the same structure as the light emitting diode package according to the twenty second and twenty third embodiments excluding a dam 2517b, which is formed instead of the second dam.

For a plan view of the light emitting diode package according to the twenty fifth embodiment, refer to FIG. 22. That is, FIG. 25a is a cross-sectional view taken at the same location as the cross-sectional view of FIG. 22b and FIG. 25b is a cross-sectional view taken at the same location as the cross-sectional view of FIG. 22c.

The light emitting diode package 25000 according to this embodiment includes a groove 2517aa and a dam 2517bb on a second interconnect pattern 2513.

Both the groove 2517a and the dam 2517b may extend inside the second interconnect pattern 2513.

The groove 2517a is formed parallel to a first insulating region 2515a and the dam 2517b is formed parallel to a second insulating region 2515b. In addition, the groove 2517a is concavely formed on an upper surface of the second interconnect pattern 2513 to expose the upper surface of the base 10 of the substrate 2510. In addition, the dam 2517b may protrude upwards from the upper surface of the second interconnect pattern 2513.

Referring to FIG. 25a, the groove 2517a may have a constant width from the top to the bottom. However, it should be understood that the structure of the groove 2517a is not limited thereto. The groove 2517a may have different widths at the top and at the bottom.

Referring to FIG. 25b, the dam 2517b may have a semi-spherical structure in which the dam 2517b has a lower height than a light emitting diode chip 2530. Accordingly, an upper surface of the dam 2517b is placed above the upper surface of the second interconnect pattern 2513. In addition, the upper surface of the dam 2517b is placed below an upper surface of the light emitting diode chip 2530.

However, it should be understood that the structures of the groove 2517a and the dam 2517b are not limited thereto. Alternatively, the groove 2517a and the dam 2517b may have any structure capable of preventing the bonding agent interposed between the light emitting diode chip 2530 and the second interconnect pattern 2513 from flowing to a protective element 2590 mounted on the first interconnect pattern 2511 or on the second interconnect pattern 2513.

According to this embodiment, the locations of the groove 2517a and the dam 2517b may be changed. That is, the groove 2517a may be formed parallel to the second insulating region 2515b and the dam 2517b may be formed parallel to the first insulating region 2515a.

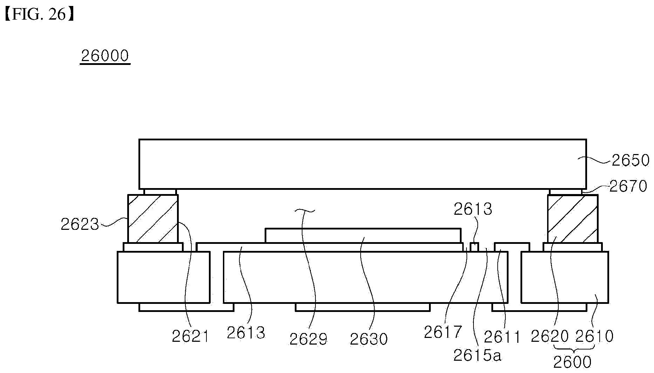

FIG. 26 is an exemplary view of a light emitting diode package according to a twenty sixth embodiment of the present disclosure.

The light emitting diode package 26000 according to the twenty sixth embodiment may have the same structure and characteristics as one of the light emitting diode packages according to the above embodiments excluding a lens 2650.

Referring to FIG. 26, the light emitting diode package 26000 may include the lens 2650 having a flat upper surface.

According to this embodiment, the lens 2650 may have a rectangular shape in which upper and lower surface are flat. Although the lens 2650 is illustrated as having a constant width from the top to the bottom in FIG. 26, it should be understood that the structure of the lens 2650 is not limited thereto. Alternatively, the lens 2650 may have any structure having a flat upper surface.

The lens 2650 is disposed on an upper surface of the sidewall 2620. In addition, a side surface of the lens 2650 may be placed between an inner side surface 121 and an outer surface 123 of the sidewall 2620. Accordingly, the lens 2650 can minimize an exposed region, as compared with a structure of the lens protruding to the outside of the light emitting diode package 2600. Accordingly, the light emitting diode package 2600 according to this embodiment can minimize the exposed region of the lens 2650 exposed to the outside, thereby improving reliability.

The lens 2650 may be disposed such that the center of the lens 2650 overlaps an optical axis of a light emitting diode chip 2630.

The lens 2650 may control a beam angle of light emitted from the light emitting diode chip 2630.

A portion of the lens 2650 facing a cavity 2629 in a horizontal direction thereof may have the same width as or a greater width than the light emitting diode chip 1030 in a horizontal direction thereof.

According to this embodiment, the lens 2650 may have a beam angle of about 100 degrees to 130 degrees by the lens 150. Preferably, the lens 2650 has a beam angle of about 110 degrees to 120 degrees.

Although some embodiments have been described herein, it should be understood that these embodiments are given by way of illustration only, and that various modifications, variations, and alterations can be made by those skilled in the art without departing from the spirit and scope of the present disclosure.

## Claims

1. A light emitting diode package comprising:
a body comprising a substrate and a sidewall formed on the substrate, the body being formed with a cavity therein; and
a light emitting diode chip mounted on the substrate in the cavity of the body,
wherein the sidewall comprises multiple inner side surfaces formed to surround the cavity,
the inner side surfaces of the sidewall comprising adjacent inner side surfaces forming an angle of 90 degrees or more therebetween, and
the substrate comprises:
an insulating base;
a first interconnect pattern formed on the base;
a second interconnect pattern spaced apart from the first interconnect pattern; and
an insulating region disposed inside the cavity to separate the first interconnect pattern from the second interconnect pattern.

2. The light emitting diode package according to claim 1, wherein the sidewall comprises an even number of inner side surfaces greater than or equal to 4.

3. The light emitting diode package according to claim 1, wherein the inner side surfaces of the sidewall comprise inner side surfaces facing each other and having the same length.

4. The light emitting diode package according to claim 1, wherein the inner side surfaces of the sidewall comprise inner side surfaces facing each other and symmetrical to each other.

5. The light emitting diode package according to claim 1, wherein an upper surface of the sidewall is divided into multiple regions, and some regions of the upper surfaces of the side wall have different areas than the other regions thereof.

6. The light emitting diode package according to claim 1, further comprising:
a lens disposed on an upper surface of the sidewall and covering the cavity.

7. The light emitting diode package according to claim 6, further comprising:
a bonding agent interposed between the lens and the upper surface of the sidewall,
wherein the upper surface of the sidewall is divided into multiple regions,
some regions of the upper surface of the side wall have different areas than the other regions thereof, and
the multiple regions comprise regions facing each other and having the same area.

8. The light emitting diode package according to claim 1, wherein the insulating region comprises a first insulating region and a second insulating region,
the first insulating region having a greater length than the second insulating region and being parallel to one side of the light emitting diode chip, and
the second insulating region being parallel to the other side of the light emitting diode chip.

9. The light emitting diode package according to claim 1, further comprising:
a short preventing portion formed on the interconnect pattern between the light emitting diode chip and the insulating region.

10. The light emitting diode package according to claim 1, wherein the short preventing portion is a groove formed on the interconnect pattern formed on an upper side of the base.

11. The light emitting diode package according to claim 9, wherein the short preventing portion is a dam formed on the interconnect pattern formed on an upper side of the base, and an upper surface of the dam is placed above an upper surface of the interconnect pattern.

12. A light emitting diode package comprising:
a body comprising a substrate and a sidewall formed on the substrate, the body being formed with a cavity therein; and
a light emitting diode chip mounted on the substrate in the cavity of the body,
wherein the sidewall comprises at least four multiple inner side surfaces formed to surround the cavity, and
the substrate comprises:
an insulating base;
a first interconnect pattern formed on the base;
a second interconnect pattern spaced apart from the first interconnect pattern;
an insulating region disposed inside the cavity to separate the first interconnect pattern from the second interconnect pattern; and
a short preventing portion disposed between the light emitting diode chip and the insulating region.

13. The light emitting diode package according to claim 12, wherein the inner side surfaces of the sidewall comprise adjacent inner side surfaces forming an angle of 90 degrees or more therebetween.

14. The light emitting diode package according to claim 12, wherein the inner side surfaces of the sidewall comprise inner side surfaces facing each other and having the same length.

15. The light emitting diode package according to claim 12, wherein the inner side surfaces of the sidewall comprise inner side surfaces facing each other and symmetrical to each other.

16. The light emitting diode package according to claim 12, wherein the insulating region comprises a first insulating region and a second insulating region,
the first insulating region having a greater length than the second insulating region and being parallel to one side of the light emitting diode chip, and
the second insulating region being parallel to the other side of the light emitting diode chip.

17. The light emitting diode package according to claim 16, wherein the short preventing portion comprises at least some region parallel to the first insulating region.

18. The light emitting diode package according to claim 16, wherein the short preventing portion comprises at least some region parallel to the second insulating region.

19. The light emitting diode package according to claim 12, wherein the short preventing portion has a groove shape or a dam shape.

20. The light emitting diode package according to claim 12, wherein the short preventing portion has a greater length than the insulating region.
